# EUROPEAN PATENT APPLICATION

(11) **EP 4 404 255 A1**
(43) Date of publication of application: **24.07.2024**
(21) Application number: 23806922.3
(22) Date of filing: 16.05.2023
(51) Int. Cl.: H01L 23/492

(54) **POWER MODULE, POWER SUPPLY SYSTEM, VEHICLE, AND PHOTOVOLTAIC SYSTEM**

(30) Priority: 18.05.2022 CN 202210542672
(71) Applicant: Huawei Digital Power Technologies Co., Ltd., Shenzhen, Guangdong 518043 (CN)
(72) Inventor: LANG, Fengqun, Shenzhen, Guangdong 518043 (CN); LI, Hui, Shenzhen, Guangdong 518043 (CN); ZHOU, Sizhan, Shenzhen, Guangdong 518043 (CN); LIU, Haiyan, Shenzhen, Guangdong 518043 (CN); CHEN, Huibin, Shenzhen, Guangdong 518043 (CN); LV, Zhen, Shenzhen, Guangdong 518043 (CN); HU, Chunfu, Shenzhen, Guangdong 518043 (CN)
(74) Representative: Gill Jennings & Every LLP
(86) International application number: PCT/CN2023/094473
(87) International publication number: WO 2023/221970

(57) **Abstract**

This application provides a power module, a power supply system, a vehicle, and a photovoltaic system. The power module includes a first metal layer-coated substrate, a plurality of chips, and a first connection piece. A first electrode of each chip is electrically connected to a first metal layer of the first metal layer-coated substrate. The first connection piece includes a first main body part and a plurality of first contact parts. A second electrode of each of the plurality of chips is in contact with at least one of the first contact parts. There is a part of the first main body part between at least one pair of adjacent first contact parts. In this application, a current flowing out from the chip may directly flow to the first main body part through the first contact part. In this way, a current flow path is shortened. The chips are connected in parallel by using the first connection piece, so that parasitic inductance of the power module can be reduced, and current equalization of the power module can be improved.

## Description

This application claims priority to Chinese Patent Application No. 202210542672.X, filed with the China National Intellectual Property Administration on May 18, 2022 and entitled "POWER MODULE, POWER SUPPLY SYSTEM, VEHICLE, AND PHOTOVOLTAIC SYSTEM", which is incorporated herein by reference in its entirety.

### TECHNICAL FIELD

This application relates to the field of semiconductor technologies, and in particular, to a power module, a power supply system, a vehicle, and a photovoltaic system.

### BACKGROUND

With the development of power electronic technology, power modules have attracted increasingly more attention. An electrical connection of a semiconductor chip in a power module is mainly implemented by using an aluminum wire soldering technology. A gate and a source of the semiconductor chip are connected to a copper layer on a surface of a substrate by using an aluminum wire. However, when a plurality of chips are arranged in the power module, a quantity of aluminum wires increases accordingly. A large quantity of aluminum wires increase parasitic inductance of the power module. In addition, when the plurality of chips are connected in parallel, currents between the plurality of chips connected in parallel are nonuniform due to connections between the plurality of aluminum wires. Amounts of heat generated by the chips connected in parallel are nonuniform due to the nonuniform currents. Serious local overheating affects performance of the chip, and affects performance of the power module.

### SUMMARY

This application provides a power module that can reduce parasitic inductance and improve current equalization.

According to a first aspect, this application provides a power module. The power module includes a first metal layer-coated substrate, a plurality of chips, and a first connection piece. The first metal layer-coated substrate includes a first insulating substrate and a first metal layer located on a side of the first insulating substrate. The first metal layer includes a first surface away from the first insulating substrate. The chip includes a first electrode and a second electrode. The plurality of chips are located on a side that is of the first metal layer and that is away from the first insulating substrate. The first electrode of each of the plurality of chips is electrically connected to the first metal layer. At least two of the plurality of chips are spaced in a first direction, and at least two of the plurality of chips are spaced in a second direction. The second direction and the first direction are parallel to the first surface and intersect. The first connection piece is located on sides that are of the plurality of chips and that are away from the first insulating substrate. The first connection piece includes a first main body part and a plurality of first contact parts. The second electrode of each of the plurality of chips is in contact with at least one of the first contact parts. There is a part of the first main body part between at least one pair of adjacent first contact parts. The first main body part and the first metal layer are spaced for insulation.

The power module includes the plurality of chips arranged in a first direction and a second direction. The plurality of chips are connected in parallel by using one first connection piece. Inductance is generally generated due to the parallel connection of the plurality of chips. In this application, there is the part of the first main body part between the at least one pair of adjacent first contact parts. Because a flow path in the first main body part is wider than a flow path of a current in the first contact part, a current flowing out from the second electrode of the chip directly flows to the first main body part. Connectivity between the plurality of chips arranged in the first direction and the second direction are enhanced, parasitic parameter consistency between the chips connected in parallel is improved, and dynamic current equalization between the plurality of chips connected in parallel is optimized. In addition, structural reliability of interconnections between the plurality of chips in the first direction and the second direction can be further improved by using the first connection piece, to ensure current transmission stability.

In a possible implementation, in a thickness direction of the chip, the first main body part is isolated from the second electrode of the chip. The first connection piece includes one or more slots. The slot protrudes from the first main body part towards the first surface, and a slot bottom of the slot is the first contact part. The first main body part is isolated from the second electrode of the chip, and the slot protrudes from the first main body part towards the first surface, so that the first main body part is above the second electrode of the chip, to improve electrical insulation between the first main body part and the first metal layer.

In a possible implementation, the first connection piece includes one or more bent structures. The bent structure includes the first contact part that is in contact with the second electrode of the chip. The bent structure is a structure that bends towards the first surface. One end that is of the bent structure and that is away from the first main body part protrudes towards the first surface. The first contact part is a protruding part, and the first contact part is in contact with the second electrode, so that the first main body part is above the second electrode, to improve the electrical insulation between the first main body part and the first metal layer.

In a possible implementation, the first connection piece is an integrally formed structure. The integrally formed structure can improve current flow smoothness, reduce current flow resistance, improve the current equalization, reduce the inductance, and further improve reliability of the first connection piece.

In a possible implementation, there is the part of the first main body part between each pair of adjacent first contact parts. In this way, each first contact part is directly connected to the first main body part, so that the current flowing out from the second electrode of each chip directly flows to the first main body part through the first contact part. The connectivity between the plurality of chips arranged in the first direction and the second direction are enhanced, the parasitic parameter consistency between the chips connected in parallel is improved, and the dynamic current equalization between the plurality of chips connected in parallel is further optimized.

In a possible implementation, the first contact parts are distributed at edges of the first main body part. A distribution region of the edges of the first main body part is large, and more first contact parts may be distributed, so that more chips may be connected in parallel, to improve power density of the power module.

In a possible implementation, the power module includes two first chip subgroups that are spaced in the first direction. The first chip subgroup includes at least two chips that are spaced in the second direction. The first main body part includes a first main branch and a plurality of first branches. The first main branch extends in the second direction, and the first branches are located on both sides of the first main branch in the first direction and are connected to the first main branch. In the first direction, the first main branch is located between the two adjacent first chip subgroups. In the second direction, the first branch is located between two adjacent first contact parts, and the first branch is connected to the two adjacent first contact parts in the second direction. The first main branch is electrically connected to the second metal layer. In this implementation, the two first chip subgroups are included. Each first chip subgroup has at least two chips. The first connection piece is connected to chips in the two first chip subgroups, so that the chips in the two first chip subgroups are connected in parallel. The first contact parts on the two adjacent chips arranged in the second direction are connected by using the first branch. At least a part of currents from the two first contact parts may flow to the first main branch through the first branch. The first branch is directly connected between the two first contact parts. In this way, a parallel connection path between the two adjacent chips may be shortened, and the current equalization can be improved.

In a possible implementation, at least some of the first contact parts are spaced from the first main branch. For example, the first contact parts on the chips at two ends of the first chip subgroup may be spaced from the first main branch, to reduce the weight of the first connection piece.

In a possible implementation, the power module further includes a second metal layer. The first metal layer and the second metal layer are located on the same side of the first insulating substrate. Orthographic projections of the first metal layer and the second metal layer are spaced on the first insulating substrate. The first connection piece further includes a second contact part, and the second contact part is electrically connected to the second metal layer. Currents obtained through converging on the first main body part may flow to the second metal layer through the second contact part. A current flow direction is sequentially as follows: an input end, the first metal layer, the first electrode of the chip, the second electrode of the chip, the first contact part, the first main body part, the second contact part, and the second metal layer.

In a possible implementation, the first contact parts close to the second contact part are further connected to the second contact part. In this way, currents flowing out from the first contact parts directly flow to the second contact part, without being detoured. Current resistance is reduced, a current flow path is shortened, and the inductance is reduced.

In a possible implementation, the first contact parts close to the second contact part are further connected to the first main branch. The first contact parts are connected to the first main branch, with no gaps between the first contact parts and the first main branch. In this way, currents flowing out from the first contact parts may directly flow to the first main branch, without being detoured. The current resistance is reduced, the current flow path is shortened, and the inductance is reduced. In this implementation, the first contact parts are connected to both the second contact part and the first main branch, to further reduce the inductance and improve the current equalization.

In a possible implementation, the first contact parts, the second contact part, and the first main body part are an integrally formed structure. The second contact part is a slot or a bent structure that is of the first connection piece and that protrudes from the first main body part towards the second metal layer. The integrally formed structure improves reliability of the first connection piece, reduces current flow resistance between the first contact parts, the second contact part, and the first main body part. In this way, the inductance is reduced and the current equalization is improved.

In a possible implementation, the first connection piece is an integrally formed rectangular sheet structure. The first contact part is a slot or a bent structure that protrudes from the first main body part towards the chip, and the second contact part is a slot or a bent structure that protrudes from the first main body part towards the second metal layer. The integrally formed rectangular sheet structure may enable the chips in the two first chip subgroups to be more closely arranged. The current equalization between the chips connected in parallel is improved, and the parasitic inductance can be effectively reduced.

In a possible implementation, the power module includes two chip groups disposed in series, which are respectively a first chip group and a second chip group. The first chip group is located on a side that is of the first metal layer and that is away from the first insulating substrate. The second chip group is located on a side that is of the second metal layer and that is away from the first insulating substrate. The power module further includes a second connection piece. The second connection piece is located on a side that is of the second chip group and that is away from the first insulating substrate. A plurality of chips in the second chip group are connected in parallel by using the second connection piece. The chip groups disposed in series can improve the power density of the power module.

In a possible implementation, the power module further includes a second metal layer-coated substrate and an electronic component. The second metal layer-coated substrate is located on the first surface. The electronic component is located on a side that is of the second metal layer-coated substrate and that is away from the first metal layer-coated substrate, and is electrically connected to the second metal layer-coated substrate.

Because a size of the electronic component is generally small, if the electronic component is directly soldered to the first metal layer-coated substrate, the metal layer of the first metal layer-coated substrate needs to be provided with an insulating groove, and two electrodes of the electronic component need to be electrically connected to the metal layers on both sides of the insulating groove. The first metal layer-coated substrate is provided with the insulating groove, and this reduces space for arranging the chips. A large quantity of chips are disposed on the first metal layer-coated substrate, and the pre-arranged chips or another electronic component may be damaged when the groove is etched into the metal layer on the first metal layer-coated substrate. In this implementation, the electronic component is joined by using the second metal layer-coated substrate. In this way, a soldering process of the electronic component is simple. When the soldering process is compared with a process in which the electronic component is directly soldered to the metal layer of the first metal layer-coated substrate, a step of providing the insulating groove on the metal layer of the first metal layer-coated substrate may be omitted. In this way, a circuit design on the first metal layer-coated substrate is simple. The insulating groove may be disposed on the second metal layer-coated substrate in advance based on the size of the electronic component and positions of the two electrodes of the electronic component. The insulating groove is etched into the second metal layer-coated substrate, without affecting performance of the chip on the first metal layer-coated substrate. Then, the electronic component is electrically connected to the second metal layer-coated substrate.

In a possible implementation, the chip further includes a third electrode. The electronic component is a gate resistor. The second metal layer-coated substrate is located on the first surface. The second metal layer-coated substrate includes a fourth electrode and a fifth electrode that are spaced for insulation. Two ends of the gate resistor are electrically connected to the fourth electrode and the fifth electrode respectively. The fourth electrode is configured to receive a drive current, and the fifth electrode is electrically connected to the third electrode of the chip by using a first conductive wire. The gate resistor is joined by using the second metal layer-coated substrate, so that the soldering process of the gate resistor is simple.

In a possible implementation, in the first metal layer-coated substrate, the first metal layer is connected to the first insulating substrate by using a metal soldering layer. The second metal layer-coated substrate further includes a second insulating substrate. The fourth electrode and the fifth electrode are attached to a surface of the second insulating substrate.

In the first metal layer-coated substrate, in a third direction, there are two metal layers on a side that is of the first insulating substrate and that faces the chip. The two metal layers are respectively the metal soldering layer and the first metal layer. If the electronic component is directly soldered to the first metal layer-coated substrate, because the electronic component needs to conduct a current, a sixth electrode and a seventh electrode that are spaced for insulation need to be disposed on the first metal layer-coated substrate. A part of a fourth metal layer and a part of the metal soldering layer that are between the sixth electrode and the seventh electrode need to be removed by using an etching process. A size of etching in the third direction is large, and this causes an increase in a diameter of a second groove. In other words, a size between the sixth electrode and the seventh electrode is large, and the size of the electronic component (for example, the gate resistor) is small, and thus cannot be soldered to the sixth electrode and the seventh electrode, or soldering reliability is poor. On this basis, the electronic component is joined by using the second metal layer-coated substrate. Metal on the second metal layer-coated substrate is directly bonded to the second insulating substrate, so that the formed fourth electrode and fifth electrode are also directly attached to the surface of the second insulating substrate. There is no metal soldering layer between the fourth electrode and the fifth electrode, and the second insulating substrate. When the groove is provided through etching to form the fourth electrode and the fifth electrode, etching on the metal soldering layer is not required. In this way, a size between the fourth electrode and the fifth electrode may be controlled to be small, and this facilitates soldering of the electronic component (for example, the gate resistor).

In an implementation, the first metal layer-coated substrate is an active metal brazed substrate. The active metal brazed substrate means that metal layers such as copper layers or aluminum layers are soldered to two surfaces of an insulating substrate by using metal solder. A circuit required by a power module, such as a first metal layer, a second metal layer, a first end metal layer, and a terminal metal layer may be formed through etching on the copper layers. A material of the first insulating substrate in the first metal layer-coated substrate may be iN or AlN, so that reliability of soldering between the first insulating substrate and metal plates on both sides of the first insulating substrate is strong. In this way, good thermal conductivity is achieved, and heat dissipation effect of the power module can be improved.

In an implementation, the second metal layer-coated substrate is a direct bond copper substrate. The second insulating substrate is an Al₂O₃ ceramic substrate or an AlN ceramic substrate, and the metal layer (for example, copper foil) is directly bonded to the second insulating substrate at a high temperature. For example, the copper foil is directly bonded to the Al₂O₃ ceramic substrate at the high temperature, and then the copper foil is configured to form the fourth electrode and the fifth electrode based on a requirement. There is no other metal layer between the copper foil and the Al₂O₃ ceramic substrate, so that a size of a spacing between the fourth electrode and the fifth electrode is small, and this facilitates soldering of the gate resistor.

In a possible implementation, in the first metal layer-coated substrate, values of thicknesses of the first metal layer and the second metal layer are greater than or equal to 0.6 mm. When the value of the thickness of the first metal layer is within the foregoing range, the first metal layer has high power density, and may quickly transmit currents to the plurality of chips connected in parallel. When the value of the thickness of the second metal layer is within the foregoing range, the first metal layer-coated substrate further has a heat conduction capability, and heat dissipation effect of the power module is further improved. In this way, the second metal layer has high power density, and may quickly transmit the currents to the plurality of chips connected in parallel in the second chip group. Larger values of the thicknesses of the first metal layer and the second metal layer indicate better heat dissipation effect and higher power density. However, thicker first metal layer and second metal layer indicate a larger size of the insulating groove when the insulating groove is provided through etching. Because the size of the electronic component (for example, the gate resistor) is small, this increases difficulty in the process of soldering the electronic component to the two electrodes across the groove. On this basis, when the power density of the power module is increased, the second metal layer-coated substrate may be provided, to reduce difficulty in the process of soldering the electronic component.

In a possible implementation, the first metal layer-coated substrate is an insulated metal substrate. The insulated metal substrate includes an insulating resin layer and metal layers located on both sides of the insulating resin layer. A required circuit is etched into the metal layer on one side based on an electrical interconnection requirement. The metal layer on one side includes the formed first metal layer and the second metal layer. When the values of the thicknesses of the metal layers are greater than or equal to 0.6 mm, the power module has high power density. The second metal layer-coated substrate may be provided, to join the electronic component and reduce the process difficulty of soldering the electronic component.

In a possible implementation, the electronic component is a thermistor. The second metal layer-coated substrate is located on the side that is of the first metal layer and that is away from the first insulating substrate, and is disposed close to the chip. The thermistor is configured to monitor a temperature of the chip. The second metal layer-coated substrate joining the thermistor and the chip are located on the first metal layer, so that accuracy of detecting the temperature of the chip can be improved.

In a possible implementation, the power module further includes a heat sink. The heat sink is located on a side that is of the first metal layer-coated substrate and that is away from the chip. A plurality of support assemblies spaced apart from each other are disposed between the heat sink and the first metal layer-coated substrate. To improve heat dissipation effect, the heat sink may be soldered, by using seventh solder, to the side that is of the first metal layer-coated substrate and that is away from the chip. Compared with a manner in which the heat sink is bonded, by using thermally conductive silicone, to the first metal layer-coated substrate, a manner in which soldering is performed uses a soldering material with better heat conduction effect than the thermally conductive silicone. Generally, when the heat sink and the first metal layer-coated substrate are soldered, pressure needs to be applied to the heat sink and the first metal layer-coated substrate. The support assembly may prevent the seventh solder, from being extruded, that is between the first metal layer-coated substrate and the heat sink and that melts during soldering with pressure applied. This avoids a case in which the seventh solder fails due to being excessively thin. Before soldering is performed, the support assembly may be bonded on a surface that is of the heat sink and that faces the first metal layer-coated substrate, or the support assembly may be bonded on a surface that is of the first metal layer-coated substrate and that faces the heat sink. The support assembly may be a metal wire or a metal strip. The support assembly may be further configured to control a thickness of the seventh solder, and a thickness of the support assembly may be designed based on a requirement, so that the seventh solder meets a requirement.

In a possible implementation, the support assembly includes two support bars disposed in parallel. The support bar includes at least two support sections. Two adjacent support sections are spaced and arranged in an extension direction of the support bar. When the seventh solder is filled between the two support bars disposed in parallel, it is difficult to extrude the seventh solder during soldering under the pressure. However, bubbles are generated during soldering under a high temperature. If the bubbles do not escape, voids are formed at a soldering layer, affecting soldering reliability. The support sections are spaced apart from each other, to help the bubbles escape and reduce the voids. In addition, the two support bars disposed in parallel may be configured to enhance support strength for the first metal layer-coated substrate and the heat sink.

According to a second aspect, this application provides a power supply system. The power supply system includes a power supply, an electric device, and the power module according to any one of the foregoing descriptions. The power supply is connected to an input end of the power module. The electric device is connected to an output end of the power module. The power module is configured to: convert a direct current output by the power supply into an alternating current, and transmit the alternating current to the electric device. The power module is a semiconductor apparatus that performs conversion on a voltage, a current, frequency, and the like of the direct current output by the power supply, and is a core apparatus for performing power conversion in the power supply system. For example, the power supply system may be used as a core apparatus for performing direct current-alternating current conversion by a motor control unit of an electric vehicle, used as a battery of the electric vehicle to output a direct current, or convert a direct current into an alternating current required for vehicle driving.

According to a third aspect, this application provides a vehicle. The vehicle includes a vehicle body and the power supply system described as above. The power supply system is installed on the vehicle body. In some implementations, the power supply system includes an inverter. The power module and a control circuit are disposed in the inverter. The control circuit is electrically connected to the power module. The control circuit may control, based on a requirement of the vehicle, performance parameters, for example, a voltage, a current, frequency, and the like of an alternating current output by the power module to a motor.

According to a fourth aspect, this application provides a photovoltaic system, including a photovoltaic module and the power module according to any one of the foregoing descriptions. The photovoltaic module is electrically connected to the power module. A direct current generated by the photovoltaic module is converted into an alternating current by using the power module.

### BRIEF DESCRIPTION OF DRAWINGS

To describe technical solutions in embodiments of this application more clearly, the following describes the accompanying drawings used in embodiments of this application.
FIG. 1 is a schematic diagram of a structure of a power supply system according to an embodiment of this application;
FIG. 2 is a schematic diagram of a structure of a vehicle according to an embodiment of this application;
FIG. 3 is a schematic diagram of a structure of a photovoltaic system according to an embodiment of this application;
FIG. 4 is a schematic diagram of a structure of a power module according to an embodiment of this application;
FIG. 5 is a sectional view of a power module according to an embodiment of this application;
FIG. 6 is a sectional view of a chip and a first metal layer-coated substrate in a power module according to an embodiment of this application;
FIG. 7 is a schematic diagram of a structure of a power module without a first connection piece according to an embodiment of this application;
FIG. 8 is a schematic diagram of a structure of a first connection piece according to an embodiment of this application;
FIG. 9 is a schematic diagram of a structure of a first connection piece according to an embodiment of this application;
FIG. 10 is a schematic diagram of a structure of a first connection piece according to an embodiment of this application;
FIG. 11 is a schematic diagram of a structure of a first connection piece according to an embodiment of this application;
FIG. 12 is a schematic diagram of a structure of a power module according to an embodiment of this application;
FIG. 13 is a schematic diagram of a structure of a second connection piece according to an embodiment of this application;
FIG. 14 is a schematic diagram of a structure of a power module according to an embodiment of this application;
FIG. 15 is a schematic diagram of a structure of a power module according to an embodiment of this application;
FIG. 16 is a partially enlarged view of an M part in FIG. 15 according to this application;
FIG. 17 is a sectional view of a part of a power module according to an embodiment of this application;
FIG. 18 is a schematic diagram of structures of a second metal layer-coated substrate and a first metal layer-coated substrate in a power module according to an embodiment of this application;
FIG. 19 is a schematic diagram of a structure in which a gate resistor is directly soldered to a first metal layer-coated substrate according to an embodiment of this application;
FIG. 20 is a partially enlarged view of an N part in FIG. 15 according to this application;
FIG. 21 is a sectional view of a part of a power module according to an embodiment of this application;
FIG. 22 is a schematic diagram of a structure in which a thermistor is directly soldered to a first metal layer-coated substrate according to an embodiment of this application;
FIG. 23a is a schematic diagram of structures of a heat sink and support assemblies according to an embodiment of this application;
FIG. 23b is a schematic diagram of structures of a heat sink and a support assembly according to an embodiment of this application;
FIG. 24 is a 3D-x-ray image of a soldering side between a heat sink and a first metal layer-coated substrate in a power module according to an embodiment of this application;
FIG. 25 is a flowchart of a preparation method for a power module according to an embodiment of this application;
FIG. 26 is a schematic diagram of a procedure in which a chip is attached to a first metal layer-coated substrate according to an embodiment of this application;
FIG. 27 is a schematic diagram of a procedure in which a chip is attached to a first metal layer-coated substrate according to an embodiment of this application;
FIG. 28 is a schematic diagram of structures of a pressure head and a chip according to an embodiment of this application;
FIG. 29 is a schematic diagram of structures of a soldering jig and a power module according to an embodiment of this application; and
FIG. 30 is a schematic diagram of a structure of a power module according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The terms "first", "second", and the like in this specification are merely intended for a purpose of description, and shall not be understood as an indication or implication of relative importance or implicit indication of a quantity of indicated technical features. Therefore, a feature limited by "first" or "second" may explicitly or implicitly include one or more features. In the descriptions of this application, unless otherwise stated, "a plurality of" means two or more than two.

In addition, in this specification, orientation terms such as "up" and "down" are defined with respect to orientations of schematically placed structures in the accompanying drawings. It should be understood that these orientation terms are relative concepts and are used for relative description and clarification. The orientation terms may vary correspondingly based on a change in an orientation in which the structure is placed.

For ease of understanding, the following first explains and describes English abbreviations and related technical terms in embodiments of this application.

MOSFET: A metal-oxide-semiconductor field-effect transistor is a metal-oxide-semiconductor field-effect transistor.

IGBT: An insulated gate bipolar transistor is an insulated gate bipolar transistor.

This application provides a power module, including a first metal layer-coated substrate, a plurality of chip, and a first connection piece. The first metal layer-coated substrate includes a first insulating substrate and a first metal layer located on a side of the first insulating substrate. The first metal layer includes a first surface away from the first insulating substrate. The chip includes a first electrode and a second electrode. The plurality of chips are located on a side that is of the first metal layer and that is away from the first insulating substrate. The first electrode of each of the plurality of chips is electrically connected to the first metal layer. At least two of the plurality of chips are spaced in a first direction, and at least two of the plurality of chips are spaced in a second direction. The second direction and the first direction are parallel to the first surface and intersect. The first connection piece is located on sides that are of the plurality of chips and that are away from the first insulating substrate. The first connection piece includes a first main body part and a plurality of first contact parts. The second electrode of each of the plurality of chips is in contact with at least one of the first contact parts. There is a part of the first main body part between at least one pair of adjacent first contact parts. The first main body part and the first metal layer are spaced for insulation. The part of the first main body part is disposed, by using the first connection piece, between the first contact parts connected to the chips, so that a current flowing out from the second electrode of the chip may directly flow to the first main body part through the first contact parts. In this way, a current flow path is shortened. The chips are connected in parallel by using the first connection piece, so that a winding length is reduced when the chips are interconnected, and the parasitic inductance of the power module can be further reduced. In addition, the first connection piece may be connected to each chip, a flow path on the first connection piece is wide, and current flow resistance is small, thereby improving current equalization between the chips of the power module.

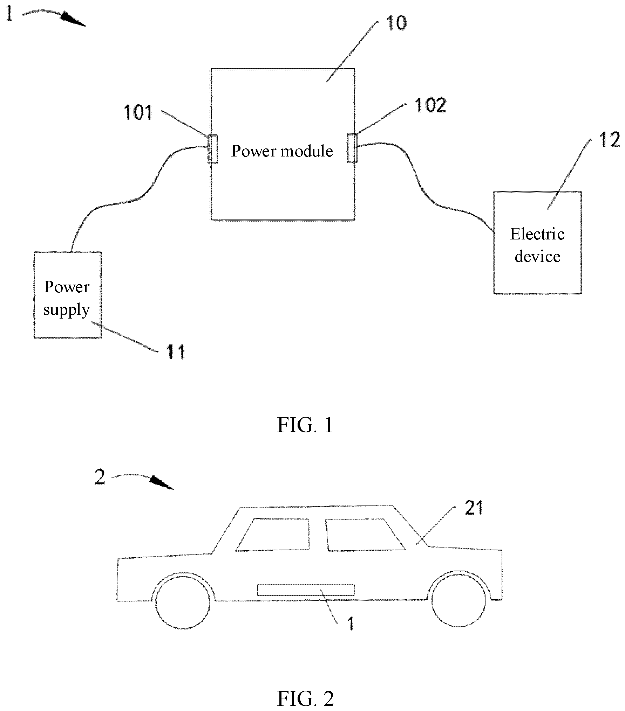

Refer to FIG. 1. An implementation of this application provides a power supply system 1. The power supply system 1 includes a power module 10, a power supply 11, and an electric device 12. The power supply 11 is connected to an input end 101 of the power module 10. The electric device 12 is connected to an output end 102 of the power module 10. The power module 10 is configured to: convert a direct current output by the power supply 10 into an alternating current, and transmit the alternating current to the electric device 12. The power module 10 is a semiconductor apparatus that performs conversion on a voltage, a current, frequency, and the like of the direct current output by the power supply 11, and is a core apparatus for performing power conversion in the power supply system 1. For example, the power supply system 1 may be used as a core apparatus for performing direct current-alternating current conversion by a motor control unit of an electric vehicle, used as a battery of the electric vehicle to output a direct current, or convert a direct current into an alternating current required for vehicle driving.

FIG. 2 shows a vehicle 2 according to an implementation of this application. The vehicle 2 includes a vehicle body 21 and the power supply system 1 described as above. The power supply system 1 is installed on the vehicle body 21. The power supply system 1 provides a power source for the vehicle 2. The power supply system 1 in this application has high power density, and may be applied to the vehicle 2 to improve power performance of the vehicle 2. The vehicle 2 includes an automobile (as shown in FIG. 2). In another implementation, the vehicle 2 includes an electric vehicle or a special purpose vehicle. The electric vehicle includes a two-wheeled, three-wheeled, or four-wheeled electric vehicle. The special purpose vehicle includes various vehicles with specific functions, for example, an engineering rescue vehicle, a street sprinkler, a suction-type sewer scavenger, a concrete mixer truck, a crane vehicle, and a medical vehicle. In this implementation, the power supply 11 is a battery in the vehicle 2, and the electric device 12 is a motor in the vehicle 2. In some implementations, the power supply system 1 includes an inverter (not shown in the figure). The power module 10 and a control circuit (not shown in the figure) are disposed in the inverter. The control circuit is electrically connected to the power module 10. The control circuit may control, based on a requirement of the vehicle 2, a performance parameter of an alternating current output by the power module 10 to the motor, for example, a voltage, a current, frequency, and the like.

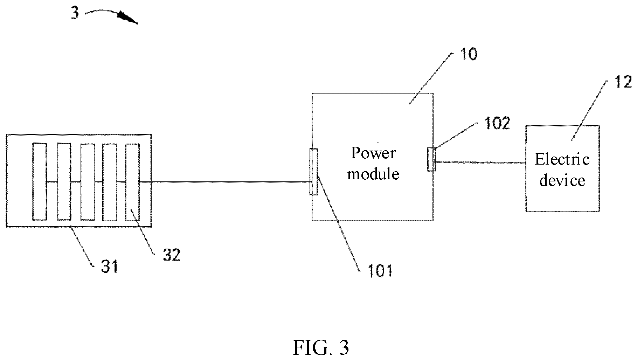

Refer to FIG. 3. The power module 10 in this application may be further applied to a photovoltaic system 3. FIG. 3 shows the photovoltaic system 3 according to an implementation of this application. The photovoltaic system 3 includes a photovoltaic module 31 and a power module 10. The photovoltaic module 31 is electrically connected to the power module 10. A direct current generated by the photovoltaic module 31 is converted into an alternating current by using the power module 10. The alternating current output by the power module 10 is transmitted to an electric device, for example, a base station or a data center.

The photovoltaic module 31 includes at least one photovoltaic panel 32, and the photovoltaic panel 32 is connected to the power module 10. In an implementation, the photovoltaic module 31 includes a plurality of photovoltaic panels 32 connected in series. In a series connection manner, after direct currents of the plurality of photovoltaic panels 32 converge, the currents are connected to the power module 10 by using a connector. In some implementations, the photovoltaic system 3 includes an inverter (not shown in the figure). The power module 10 and a control circuit (not shown in the figure) are disposed in the inverter. The control circuit is electrically connected to the power module 10. The control circuit may control, based on a requirement of the electric device, a performance parameter of an alternating current output by the power module 10, for example, a voltage, a current, frequency, and the like.

The following specifically describes the power module 10 provided in this application with reference to the accompanying drawings and specific implementations.

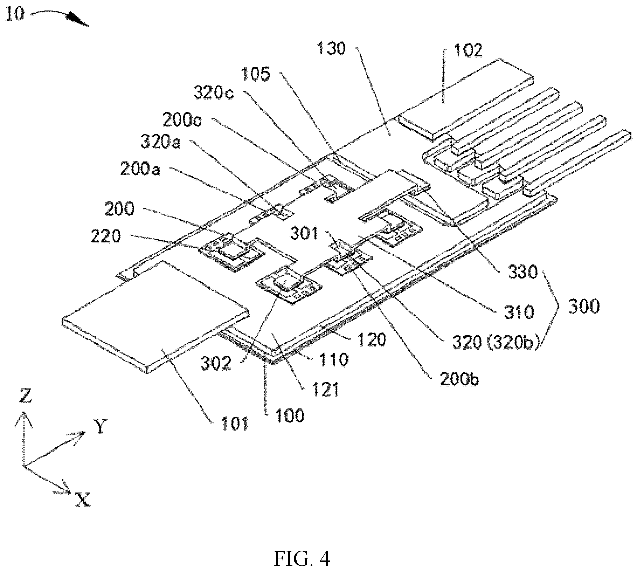

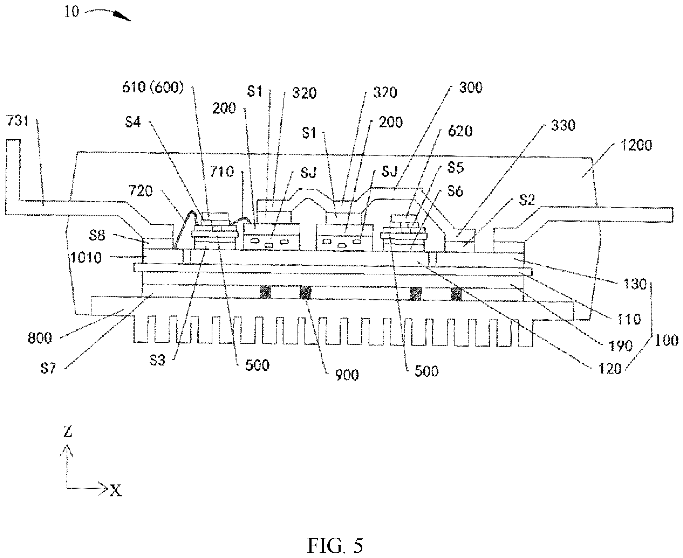

Refer to FIG. 4 and FIG. 5. FIG. 4 is a schematic diagram of a structure of the power module 10 according to an implementation of this application. FIG. 5 is a sectional view of the power module 10 according to an implementation of this application. The power module 10 includes a first metal layer-coated substrate 100, a plurality of chips 200, and a first connection piece 300. The first metal layer-coated substrate 100 includes a first insulating substrate 110, and a first metal layer 120 and a second metal layer 130 that are located on a same side of the first insulating substrate 110. The first metal layer 120 and the second metal layer 130 are located on the same side of the first insulating substrate 110, and the first metal layer 120 and the second metal layer 130 are spaced for insulation. The first metal layer 120 includes a first surface 121 away from the first insulating substrate 110.

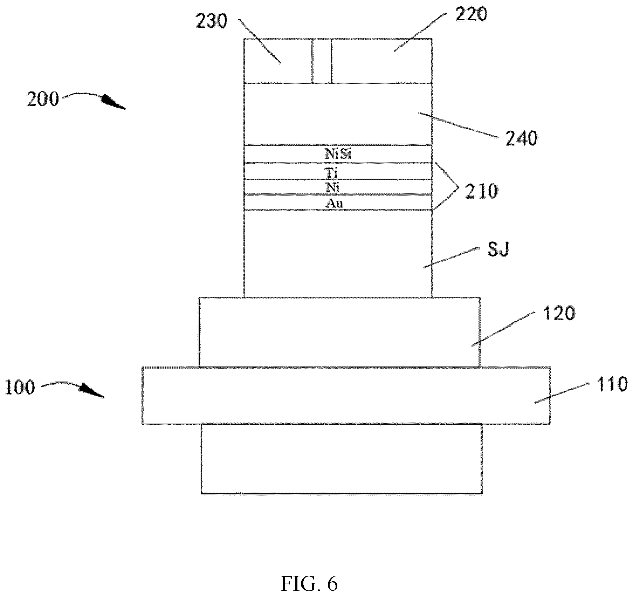

The chip 200 includes a first electrode 210 and a second electrode 220 (as shown in FIG. 6). The plurality of chips 200 are located on a side that is of the first metal layer 120 and that is away from the first insulating substrate 110. The first electrode 210 of each of the plurality of chips 200 is electrically connected to the first metal layer 120. At least two of the plurality of chips 200 are spaced in a first direction X (as shown in FIG. 4). At least two of the plurality of chips 200 are spaced in a second direction Y The second direction Y and the first direction X are parallel to the first surface 121 and intersect.

The first connection piece 300 is located on sides that are of the plurality of chips 200 and that are away from the first insulating substrate 110. The first connection piece 300 includes a first main body part 310 and a plurality of first contact parts 320. The first contact parts 320 are electrically connected to the first main body part 310. The second electrode 220 of each of the plurality of chips 200 is in contact with at least one of the first contact parts 320. There is a part of the first main body part 310 between at least one pair of adjacent first contact parts 320. The first main body part 310 and the first metal layer 120 are spaced for insulation.

The first metal layer-coated substrate 100 includes a first insulating substrate 110 and metal layers located on both sides of the first insulating substrate 110. The metal layers on both the sides are insulated by using the first insulating substrate 110. The metal layers located on the same side of the first insulating substrate 110 include the first metal layer 120 and the second metal layer 130.

The first metal layer 120 and the second metal layer 130 are located on the same side of the first insulating substrate 110. Orthographic projections of the first metal layer 120 and the second metal layer 130 are spaced on the first insulating substrate 110, so that the first metal layer 120 and the second metal layer 130 are spaced for insulation. For example, the first metal layer 120 and the second metal layer 130 may be spaced for insulation by using a first groove 105 (as shown in FIG. 4), to block current transmission between the first metal layer 120 and the second metal layer 130. For example, to better insulate the first metal layer 120 and the second metal layer 130, the first groove 105 may be filled with an insulating medium. The first main body part 310 is further electrically connected to the second metal layer 130, to transmit currents flowing to the first main body part 310 to the second metal layer 130, or transmit a current at the second metal layer 130 to the chip 200 through the first connection piece 300.

Sizes of the first metal layer 120 and the second metal layer 130, and positions at which the first metal layer 120 and the second metal layer 130 are disposed may be set based on a requirement. In this implementation, the plurality of chips 200 are disposed on the first metal layer 120. Generally, an area of the first metal layer 120 is large and occupies most of a region of the first metal layer-coated substrate 100. The second metal layer 130 is configured to be connected to a connection terminal of the power module 10. The second metal layer 130 may be disposed at an edge position of the first metal layer-coated substrate 100.

Refer to FIG. 6. The chip 200 includes a first electrode 210, a second electrode 220, a third electrode 230, and a chip body 240. The first electrode 210, the second electrode 220, and the third electrode 230 are located on the chip body 240. When the chip 200 is a MOSFET, the first electrode 210 of the chip 200 is a drain of the MOSFET, the second electrode 220 of the chip 200 is a source of the MOSFET, and the third electrode 230 of the chip 200 is a gate of the MOSFET. When the chip 200 is an IGBT, the first electrode 210 of the chip 200 is a collector of the IGBT, the second electrode 220 of the chip 200 is an emitter of the IGBT, and the third electrode 230 of the chip 200 is a gate of the IGBT. For example, the chip 200 is the MOSFET. When the third electrode 230 (the gate) receives a drive signal, the first electrode 210 (the drain) and the second electrode 220 (the source) are controlled to be connected. In this application, the first electrode 210 of the chip 200 is electrically connected to the first metal layer 120, so that a current at the first metal layer 120 may be transmitted to the inside of the chip body 240 through the first electrode 210, and transmitted to the second electrode 220. In this implementation, the first electrode 210 is located on a surface that is of the chip body 240 and that is close to the first metal layer 120. The second electrode 220 is located on a surface that is of the chip body 240 and that is away from the first metal layer 120. The third electrode 230 and the second electrode 220 are disposed on a side that is of the chip body 240 and that is away from the first metal layer 120. The third electrode 230 and the second electrode 220 are spaced for insulation.

In an implementation, a material of the chip body 240 is SIC (silicon carbide). The SIC may increase working frequency of the chip 200, and may reduce a volume of the chip 200 when same working frequency is met. In this way, more space may be reserved on the first metal layer-coated substrate 100 for mounting the electronic component of the power module 10, such as the thermistor or the gate resistor. In addition, high working frequency of the chip 200 may reduce a volume of an electronic component, such as a capacitor or a coil, around the power module 10. However, higher working frequency of the chip 200 indicates that current equalization between the plurality of chips 200 in the power module 10 is difficult to control, which may lead to a failure of the power module 10. Therefore, this application provides the first connection piece 300 that can improve the current equalization of the power module 10.

Still refer to FIG. 4. In this application, the first connection piece 300 includes the first main body part 310 and the plurality of first contact parts 320 electrically connected to the first main body part 310. The plurality of chips 200 in the power module 10 are connected in parallel by using the first connection piece 300. The pair of adjacent first contact parts 320 is two adjacent first contact parts 320. There is a part of the first main body part 310 between the at least one pair of adjacent first contact parts 320, so that a current flowing out from the first contact part 320 may directly flow to the first main body part 310. In this way, a current flow path is shortened to reduce the inductance. In an implementation, there is the part of the first main body part 310 between each pair of adjacent first contact parts 320, so that a current flowing out from each first contact part 320 may directly flow to the first main body part 310. In this way, the current flow path is further shortened to reduce the inductance.

In a specific implementation, there is a part of the first main body part 310 between two first contact parts 320 arranged in the first direction X, so that currents flowing out from the two first contact parts 320 arranged in the first direction X may directly flow to the first main body part 310. In this way, the current flow path is shortened. For example, a second electrode of a chip 200a is in contact with a first contact part 320a. A second electrode of a chip 200b is in contact with a first contact part 320b. The first contact part 320a and the first contact part 320b are a pair of adjacent first contact parts. There is a part of the first main body part 310 between the first contact part 320a and the first contact part 320b, so that a current flowing out from the chip 200a directly flows to the first main body part 310 through the first contact part 320a, and a current flowing out of the chip 200b directly flows to the first main body part 310 through the first contact part 320b. In this way, current flow paths of the chip 200a and the chip 200b are shortened.

There is a part of the first main body part 310 between two first contact parts 320 arranged in the second direction Y, so that currents flowing out from the two first contact parts 320 arranged in the second direction Y may directly flow to the first main body part 310. In this way, the current flow path is shortened. For example, the second electrode of the chip 200a is in contact with the first contact part 320a. A second electrode of a chip 200c is in contact with a first contact part 320c. The first contact part 320a and the first contact part 320c are a pair of adjacent first contact parts. There is a part of the first main body part 310 between the first contact part 320a and the first contact part 320c, so that the current flowing out from the chip 200a directly flows to the first main body part 310 through the first contact part 320a, and a current flowing out of the chip 200c directly flows to the first main body part 310 through the first contact part 320c. In this way, current flow paths of the chip 200a and the chip 200c are shortened.

Because the first main body part 310 has a wide flow path, flow paths are short when currents flowing out from the chips 200 directly flow to the first main body part 310, and the parasitic inductance can be reduced. The chips 200 are connected in parallel on the first connection piece 300, so that the chips 200 are distributed in a centralized manner, and the current equalization between the chips 200 can be improved.

In this implementation, the power module 10 further includes an input end 101 and an output end 102 (as shown in FIG. 4). The input end 101 is configured to input a current, and the input end 101 is electrically connected to the first metal layer 120. After the input end 101 inputs a current based on a requirement, the current flows to the chip 200 through the first metal layer 120. After the current in the chip 200 flows from the first electrode 210 to the second electrode 220, the first contact part 320 is configured to guide the current of the second electrode 220 to the first main body part 310. The first main body part 310 is configured to transmit currents after the currents converge to the second metal layer 130. The currents flow to the output end 102 through the second metal layer 130, and flow out from the power module 10 through the output end 102. A current flow direction is sequentially as follows: the input end 101, the first metal layer 120, the first electrode 210 of the chip 200, the second electrode 220 of the chip 200, the first contact part 320, the first main body part 310, the second metal layer 130, and the output end 102.

If a solution in which the first main body part 310 conducts the current of each chip 200 directly to the second metal layer 130 through the first contact part 320 is not provided, the length of each first contact part 320 needs to be increased, so that the first contact part 320 is connected to the second metal layer 130. Moreover, increasing the length of each first contact part 320 increases wiring of the plurality of first contact parts 320, and enhances the parasitic inductance. The plurality of chips 200 connected in parallel may be connected together by using only the second metal layer 130. As a result, parasitic parameter consistency of the plurality of chips 200 is poor, and the current equalization of the chips 200 is poor. If the first contact part 320 and the second metal layer 130 are connected by using an aluminum wire, parasitic inductance of the aluminum wire is stronger, and the current equalization of the plurality of chips 200 connected in parallel is worse. If two or more chips 200 in the second direction Y are connected by using a same connection piece, and the connection piece is connected to the second metal layer 130, the parasitic inductance can be reduced, compared with the parasitic inductance generated when a manner of connecting the chips by using the aluminum wire is used. However, the chips 200 are connected at different positions of the connection piece, and the chips 200 are at different distances from the second metal layer 130. A current flowing out from a chip 200 furthest from the second metal layer 130 further needs to flow through a part of the connection piece on an adjacent chip 200 in the second direction Y As a result, current flow resistance of the chip 200 close to the second metal layer 130 increases, the parasitic inductance is also increased, and the current equalization between the chips 200 connected in parallel deteriorates.

In this application, the current does not need to flow through the first contact part 320 on the second electrode 220 of each chip 200. Because a flow path in the first main body part 310 is wider than a flow path of a current in the first contact part 320, a current flowing out from the second electrode 220 of each chip 200 directly flows to the first main body part 310. Connectivity between the plurality of chips 200 arranged in the first direction X and the second direction Y are enhanced, the parasitic parameter consistency between the chips 200 connected in parallel is improved, and the dynamic current equalization between the plurality of chips 200 connected in parallel is optimized. In addition, structural reliability of interconnections between the plurality of chips 200 in the first direction X and the second direction Y can be further improved by using the first connection piece 300, to ensure the current transmission stability.

To save space of the power module 10 and simplify component arrangement on the power module 10, in this implementation, the first direction X is a length direction of the power module 10, and the second direction Y is a width direction of the power module 10. In some implementations, the first direction X is the width direction of the power module 10, and the second direction Y is the length direction of the power module 10. To adapt to the arrangement of components in the power module 10, in some implementations, the first direction X intersects the width direction of the power module 10, and the second direction Y intersects the length direction of the power module 10.

Still refer to FIG. 4. In a possible implementation, in a thickness direction of the chip 200, the first main body part 310 is isolated from the second electrode 220 of the chip 200. The first connection piece 300 includes one or more slots 301. The slot 301 protrudes from the first main body part 310 towards the first surface 121, and a slot bottom of the slot 301 is the first contact part 320. The thickness direction of the chip 200 is a third direction Z, and the third direction Z perpendicularly intersects both the first direction X and the second direction Y The first main body part 310 is isolated from the second electrode 220 of the chip 200. The slot 301 protrudes from the first main body part 310 towards the first surface 121, so that the first main body part 310 is above the second electrode 220 of the chip 200, to improve electrical insulation between the first main body part 310 and the first metal layer 120. In an implementation, the entire first contact part 320 may be the slot bottom of the slot 301.

It should be noted that, in a possible implementation, a peripheral wall of the slot may be complete, that is, a cross section of the peripheral wall of the slot may be a complete ring-shaped structure. In another possible implementation, the peripheral wall of the slot may also be incomplete, that is, a cross section of the peripheral wall of the slot is an opening structure. As shown in the first contact part 320a or 320b in FIG. 4, the first contact part 320a or 320b is specifically a slot, but the cross section of the peripheral wall of the slot is a U-shaped structure. It should be understood that, when the cross section of the peripheral wall of the slot is the opening structure, the opening structure may alternatively specifically be L-shaped, V-shaped, or the like.

In a possible implementation, in the thickness direction of the chip 200, the first main body part 310 is isolated from the second electrode 220 of the chip 200. The first connection piece 300 includes one or more bent structures 302. The bent structure 302 includes the first contact part 320 that is in contact with the second electrode 220 of the chip 200. The bent structure 302 is a structure that bends towards the first surface 121. One end that is of the bent structure 302 and that is away from the first main body part 310 protrudes towards the first surface 121. The first contact part 320 is a protruding part, and the first contact part 320 is in contact with the second electrode 220, so that the first main body part 310 is above the second electrode 220, to improve the electrical insulation between the first main body part 310 and the first metal layer 120. In an implementation, the entire first contact portion 320 may be a part that is of the bent structure 302 and that is in contact with the second electrode 220 of the chip 200. In an implementation, a part of the first contact part 320 may be the slot bottom of the slot 301, and a part of the first contact part 320 may be the part that is of the bent structure 302 and that is in contact with the second electrode 220 of the chip 200.

In a possible implementation, the first contact parts 320 are distributed at edges of the first main body part 310. A distribution region of the edges of the first main body part 310 is large, and more first contact parts 320 may be distributed, so that more chips 200 may be connected in parallel, to improve power density of the power module 10.

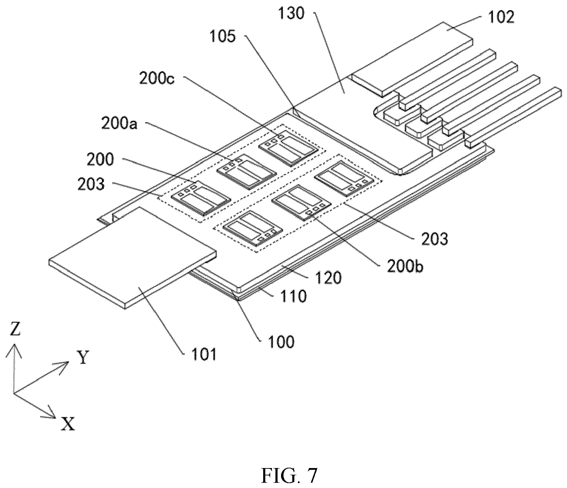

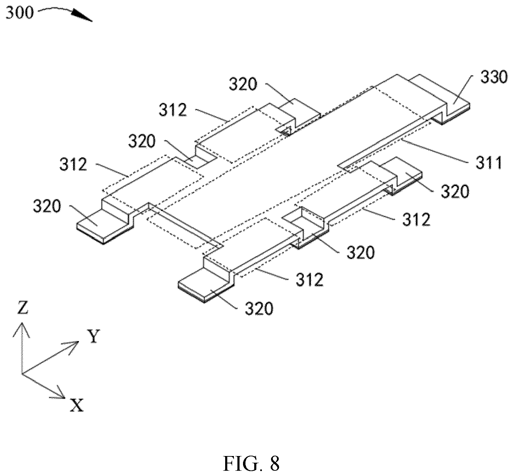

Refer to FIG. 4, FIG. 7, and FIG. 8. FIG. 7 is a schematic diagram of a structure without the first connection piece 300 in FIG. 4. FIG. 8 is a schematic diagram of a structure the first connection piece 300. In a possible implementation, the power module 10 includes two first chip subgroups 203 (as shown in FIG. 7) that are spaced in the first direction X. The first chip subgroup 203 includes at least two chips 200 that are spaced in the second direction Y The first main body part 310 includes a first main branch 311 and a plurality of first branches 312 (as shown in FIG. 8). The first main branch 311 extends in the second direction Y, and the first branches 312 are located on both sides of the first main branch 311 in the first direction X and are connected to the first main branch 311. In the first direction X, the first main branch 311 is located between the two adjacent first chip subgroups 203. In the second direction Y, the first branch 312 is located between two adjacent first contact parts 320, and the first branch 312 is connected to the two adjacent first contact parts 320 in the second direction Y The first main branch 311 is electrically connected to the second metal layer 130.

In the implementations shown in FIG. 4 and FIG. 7, the two first chip subgroups 203 are included. Each first chip subgroup 203 has three chips 200. The first connection piece 300 is connected to the chips 200 in the two first chip subgroups 203, so that the chips 200 in the two first chip subgroups 203 are connected in parallel. The first contact parts 320 on the two adjacent chips 200 arranged in the second direction Y are connected by using the first branch 312. At least a part of currents from the two first contact parts 320 may flow to the first main branch 311 through the first branch 312. The first branch 312 is directly connected between the two first contact parts 320. In this way, a parallel connection path between the two adjacent chips 200 may be shortened, and the current equalization can be improved.

In an implementation, at least some of the first contact parts 320 are spaced from the first main branch 311. For example, the first contact parts 320 on the chips 200 at two ends of the first chip subgroup 203 may be spaced from the first main branch 311, to reduce the weight of the first connection piece 300.

Still refer to FIG. 4. In an implementation, the first connection piece 300 further includes a second contact part 330. The second contact part 330 is located on a side that is of the second metal layer 130 and that is away from the first insulating substrate 110, and is electrically connected to the second metal layer 130. In the second direction Y, the second contact part 330 is located on an end of the first main body part 310, and is connected to the first main body part 310. Specifically, the second contact part 330 is located on an end of the first main branch 311 (as shown in FIG. 8). The input end 101 is located on a side that is of the first main branch 311 and that is away from the second contact part 330. In an implementation, the second contact part 330 and the second metal layer 130 are connected through soldering. Currents obtained through converging on the first main body part 310 may flow to the second metal layer 130 through the second contact part 330. A current flow direction is sequentially as follows: the input end 101, the first metal layer 120, the first electrode 210 of the chip 200, the second electrode 220 of the chip 200, the first contact part 320, the first main body part 310, the second contact part 330, and the second metal layer 130.

In FIG. 4, to implement a specific circuit design requirement of the power module 10, first contact parts 320c close to the second contact part 330 may be spaced from the first main branch 311.

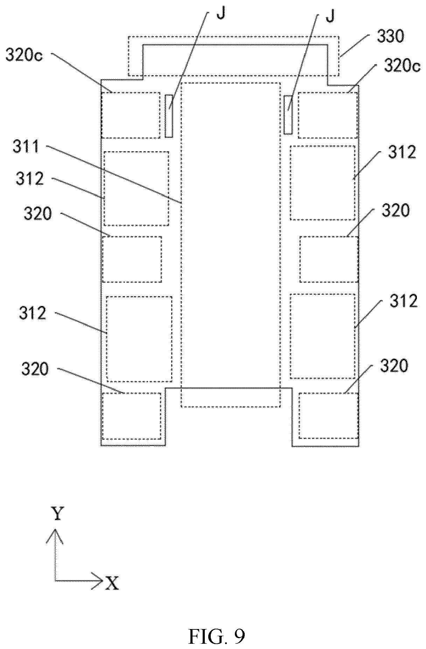

Refer to FIG. 9. In a possible implementation, the first contact parts 320c close to the second contact part 330 are further connected to the second contact part 330. In this way, currents flowing out from the first contact parts 320c directly flow to the second contact part 330, without being detoured. Current resistance is reduced, a current flow path is shortened, and the inductance is reduced. In the implementation shown in FIG. 9, the first contact parts 320c are spaced from the first main branch 311 by using gaps J.

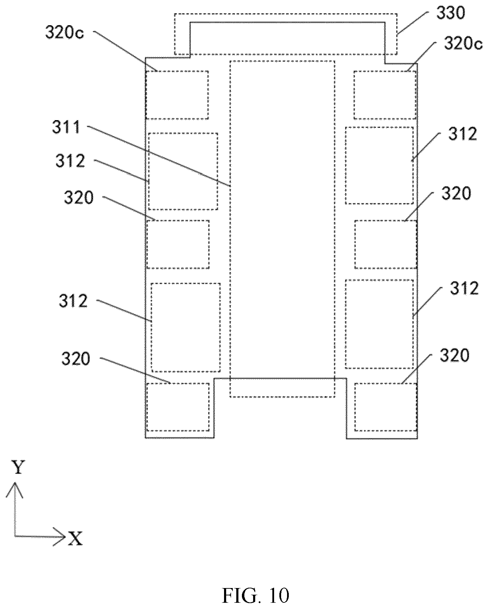

Refer to FIG. 10. In a possible implementation, the first contact parts 320c close to the second contact part 330 are further connected to the first main branch 311. The first contact parts 320c are connected to the first main branch 311, with no gaps between the first contact parts 320c and the first main branch 311. In this way, currents flowing out from the first contact parts 320c may directly flow to the first main branch 311, without being detoured. The current resistance is reduced, the current flow path is shortened, and the inductance is reduced. In this implementation, the first contact parts 320c are connected to both the second contact part 330 and the first main branch 311, to further reduce the inductance and improve the current equalization.

Still refer to FIG. 8. In a possible implementation, the first contact parts 320, the second contact part 330, and the first main body part 310 are an integrally formed structure. The first contact part 320 protrudes from the first main body part 310 towards the chip 200, and the second contact part 330 protrudes from the first main body part 310 towards the second metal layer 130.

In this implementation, the first connection piece 300 is an integrally formed structure. A part, of the first connection piece 300, located on a side that is of the chip 200 and that is away from the first insulating substrate 110 protrudes towards the chip 200 to form the first contact part 320. A part, of the first connection piece 300, located on the side that is of the second metal layer 130 and that is away from the first insulating substrate 110 protrudes towards the first insulating substrate 110 to form the second contact part 330. A part of the first connection piece 300 other than the first contact parts 320 and the second contact part 330 is the first main body part 310. In this implementation, the first contact parts 320, the second contact part 330, and the first main body part 310 are an integrally formed structure. The first contact parts 320, the second contact part 330, and the first main body part 310 may be formed by using a stamping process and a die casting process. Compared with a case in which the first contact parts 320, the second contact part 330, and the first main body part 310 are connected by using another component to form the first connection piece 300, a case in which the first contact parts 320, the second contact part 330, and the first main body part 310 are an integrally formed structure can improve current flow smoothness, reduce the current flow resistance, improve the current equalization, and reduce the inductance. In addition, reliability of the first connection piece 300 can be improved.

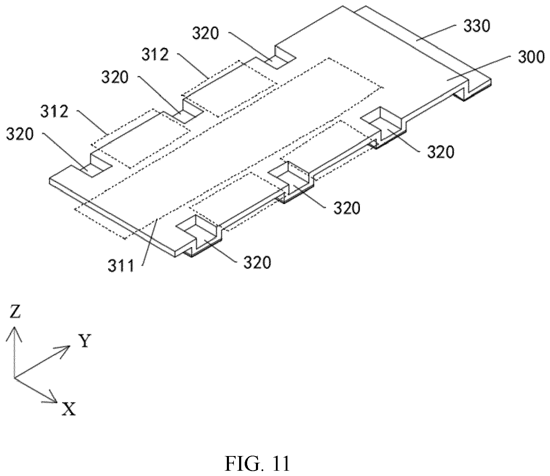

Refer to FIG. 11. In a possible implementation, the first connection piece 300 is an integrally formed rectangular sheet structure. The first contact part 320 is a slot or a bent structure that protrudes from the first main body part 310 towards the chip 200, and the second contact part 330 is a slot or a bent structure that protrudes from the first main body part 310 towards the second metal layer 130. The integrally formed rectangular sheet structure may enable the chips 200 in the two first chip subgroups 203 to be more closely arranged. The current equalization between the chips 200 connected in parallel is improved, and the parasitic inductance can be effectively reduced.

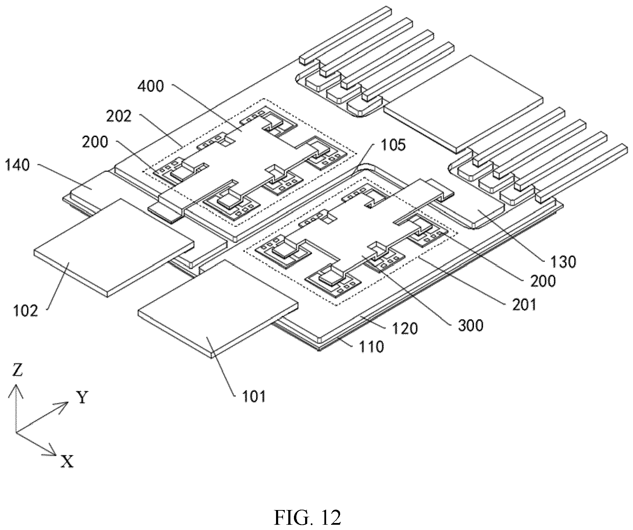

Refer to FIG. 12. In a possible implementation, the power module 10 includes two chip groups disposed in series, which are respectively a first chip group 201 and a second chip group 202. The first chip group 201 is located on the side that is of the first metal layer 120 and that is away from the first insulating substrate 110. The second chip group 202 is located on the side that is of the second metal layer 130 and that is away from the first insulating substrate 110. The power module 10 further includes a second connection piece 400. The second connection piece 400 is located on a side that is of the second chip group 202 and that is away from the first insulating substrate 110. The plurality of chips 200 in the second chip group 202 are connected in parallel by using the second connection piece 400.

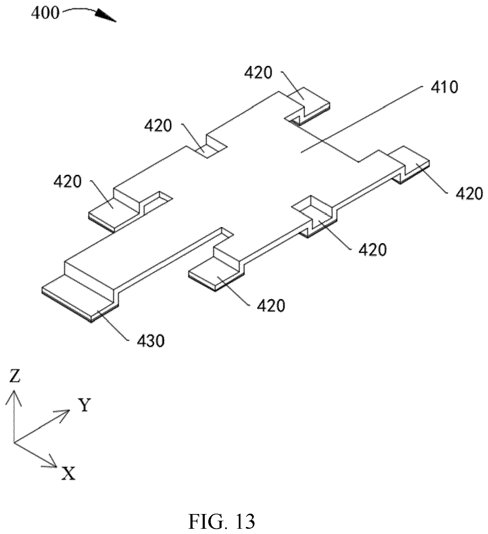

As shown in FIG. 13, the second connection piece 400 includes a second connection main body 410, and a plurality of third connection structures 420 and a fourth connection structure 430 that are electrically connected to the second connection main body 410. The plurality of third connection structures 420 are electrically connected to the plurality of chips 200 in the second chip group 202 respectively. A part of the second connection main body 410 is located between two third connection structures 420 arranged in the first direction X, and a part of the second connection main body 410 is located between two third connection structures 420 arranged in the second direction Y The second connection main body 410 and the second metal layer 130 are spaced for insulation. The fourth connection structure 430 is electrically connected to the output end 102 of the power module 10. In this implementation, the second connection piece 400 and the first connection piece 300 are disposed reversely, and the output end 102 and the input end 101 are located on a same end of the power module 10. In this implementation, the second connection main body 410 includes a second main branch and second branches. Structures of the second main branch and the second branches in the second connection piece 400 are the same as the structures of those in the first connection piece 300. The various implementations of the first connection piece 300 are also applicable to the second connection piece 400. Details are not described herein again.

In this implementation, the power module 10 further includes a first end metal layer 140. The first end metal layer 140 is spaced from the first metal layer 120 and the second metal layer 130 for insulation. The fourth connection structure 430 is electrically connected to the output end 102 by using the first end metal layer 140. The fourth connection structure 430 is fastened to the first end metal layer 140, and the first end metal layer 140 is connected to the output end 102.

In this implementation, after the input end 101 inputs a current, a flow path direction of the current is as follows: the input end 101, the first metal layer 120, the first chip group 201, the first connection piece 300, the second metal layer 130, the second chip group 202, the second connection piece 400, the first end metal layer 140, and the output end. The chips 200 in the first chip group 201 are connected in parallel by using the first connection piece 300, and the chips 200 in the second chip group 202 are connected in parallel by using the second connection piece 400.

In some implementations, for the power module 10, a quantity of chip groups and a quantity of chips 200 in each chip group may be set based on a requirement. Manners of a serial connection or a parallel connection between the chip groups may be set based on a requirement.

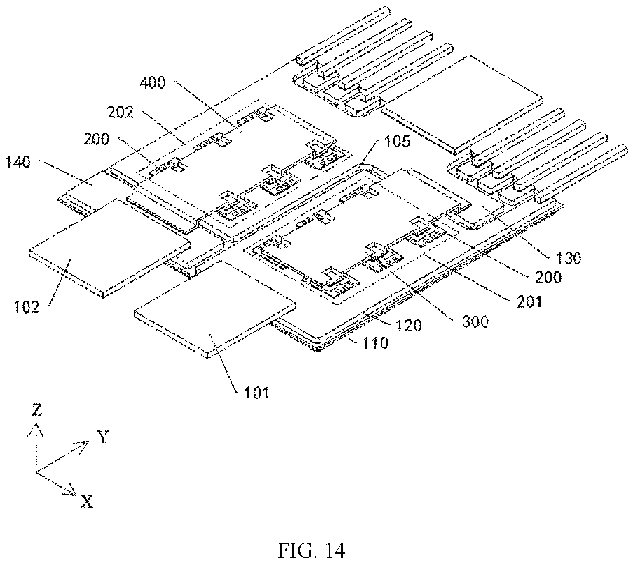

Refer to FIG. 14. In a possible implementation, the power module 10 includes two chip groups disposed in series, which are respectively the first chip group 201 and the second chip group 202. The first chip group 201 is located on the side that is of the first metal layer 120 and that is away from the first insulating substrate 110. The second chip group 202 is located on the side that is of the second metal layer 130 and that is away from the first insulating substrate 110. The power module 10 further includes the first connection piece 300 and the second connection piece 400. The first connection piece 300 is located on a side that is of the first chip group 201 and that is away from the first insulating substrate 110. The plurality of chips 200 in the first chip group 201 are connected in parallel by using the first connection piece 300. The second connection piece 400 is located on the side that is of the second chip group 202 and that is away from the first insulating substrate 110. The plurality of chips 200 in the second chip group 202 are connected in parallel by using the second connection piece 400. In this implementation, a structure manner of the first connection piece 300 shown in FIG. 11 is used as a structure manner of the first connection piece 300, and a structure of the second connection piece 400 is the same as that of the first connection piece 300.

In this application, to describe structure advantages of the first connection piece 300 and the second connection piece 400 in FIG. 12, and the first connection piece 300 and the second connection piece 400 in the implementation shown in FIG. 14, simulation tests are performed on the implementations shown in FIG. 12 and FIG. 14, finding that parasitic inductance of the power module 10 shown in FIG. 14 is less than parasitic inductance of the power module 10 shown in FIG. 12. This indicates that the first connection piece 300 and the second connection piece 400 in FIG. 14 are integrally formed rectangular structures, the current equalization between the chips 200 connected in parallel can be effectively improved, and the parasitic inductance can be effectively reduced. In this application, simulation tests are further performed on the implementation shown in FIG. 12 and the manner in which the chips 200 are connected in parallel by using conductive wires, showing that in the implementation shown in FIG. 12, the current equalization between the chips 200 connected in parallel can be effectively improved, and the parasitic inductance can be effectively reduced.

Still refer to FIG. 5. In an implementation, the first contact part 320 may be soldered to the second electrode 220 of the chip 200 by using first solder S1, and the second contact part 330 may be soldered to the second metal layer 130 by using second solder S2. The first solder S1 and the second solder S2 may be selected from at least one of tin solder and lead solder. The tin solder may be selected from at least one of SnSb5, SnSb8, SnSbAg, SAC305, multi-element reinforced SAC, and SnSb10. Materials of the first solder S1 and the second solder S2 may be selected based on a requirement. The first solder S1 may be the same as or different from the second solder S2. In SnSb5, a weight percentage of Sb is 5%. In SnSb8, a weight percentage of Sb is 8%. In SnSb10, a weight percentage of Sb is 10%. SAC in SAC306 represents three metal elements, Sn, Ag, and Cu, indicating that the product is made of the three metal components, Sn (tin), Ag (silver) and Cu (copper), where 3 represents 3% of Ag, and 05 represents 0.5% of Cu. The multi-element reinforced SAC includes other metal components in the three metal components Sn (tin), Ag (silver), and Cu (copper) to enhance solder reliability.

Still refer to FIG. 5, in a possible implementation, the chip 200 is connected to the first metal layer 120 by using a sintered material SJ. For example, the sintered material SJ may be formed by silver paste, copper paste, or a silver film. In a specific implementation, the silver paste may include at least one of micrometer silver particle paste (micrometer silver particle paste) and nanometer silver particle paste (nanometer silver particle paste). The micrometer silver particle paste is silver paste made by micron silver particles and an organic solvent, and the micrometer silver particle paste is low in costs and is safe. Sintering is usually performed with pressure applied. The sintered material SJ has high densification performance, and an interface of a bonded body is firmly boned. Bonding reliability is high.

Optionally, to improve reliability of bonding through sintering and reduce the costs, the sintered material SJ in this application may be formed by using the micrometer silver particle paste (micrometer silver particle paste).

To improve the reliability of bonding through sintering, an elastic modulus, a coefficient of thermal expansion (CTE), and the like of the sintered material SJ may be adjusted by adding a material to the sintered material SJ. For example, the sintered material SJ includes a main material and filler filled in the main material. The main material includes at least one of the silver paste, the copper paste, or the silver film. The filler is made by a material having good performance of bonding with the main material. A coefficient of thermal expansion of the filler is less than a coefficient of thermal expansion of the main material. In this way, the reliability of bonding through sintering is improved.

For example, the main material is the micrometer silver particle paste. The filler is added to the micrometer silver particle paste, to reduce the coefficient of thermal expansion of the micrometer silver particle paste and reduce bonding stress. In this way, the reliability of bonding through silver sintering is improved. For example, the filler may include at least one of nickel (Ni), a Ni alloy, copper (Cu), copper-plated nickel, titanium (Ti), a Ti alloy, iron (Fe), a Fe alloy, a Kovar alloy (Kovar, an iron-nickel-cobalt alloy 4J29), and SiC powder. This is not limited herein.

A shape of the filler is not limited in this application. For example, a length of the filler may be controlled to be between 20 µm and 100 µm, and a size of the filler in a vertical length direction may be controlled to be between 20 nm and 30 µm. A cross section in the length direction may be a circle, an ellipse, a polygon, or the like.

In this application, the first metal layer 120 is generally the copper. When the sintered material SJ is the silver paste or the silver film, to improve performance of bonding between the sintered material SJ and the first metal layer 120, the first metal layer 120 may be silver-plated at a sintered position, that is, the first metal layer 120 is covered with a silver-plated layer in a region corresponding to the sintered material. For example, a thickness of the silver-plated layer may be controlled to be between 0.1 µm and 30 µm. If the sintered material SJ is well bonded with the first metal layer-coated substrate, silver plating may not be required. For example, when the sintered material is the copper paste, the first metal layer-coated substrate 100 does not need to be plated with silver at the sintered position.

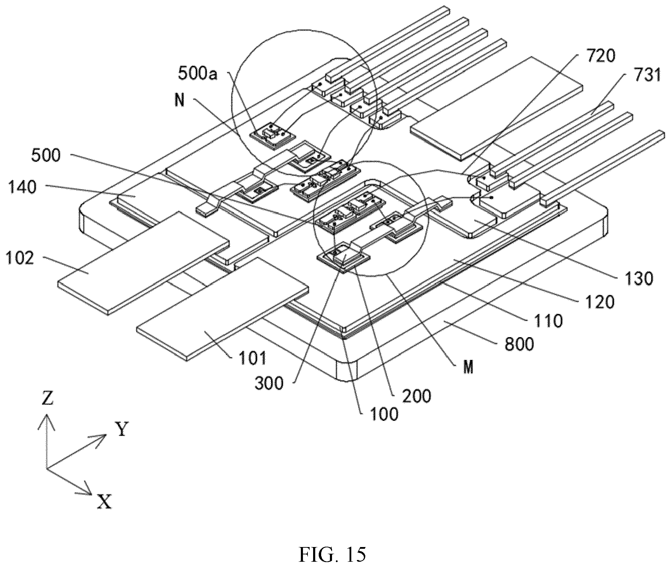

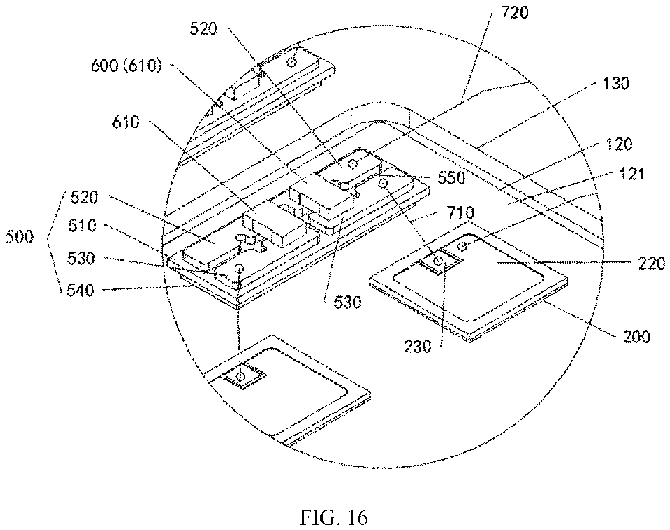

Refer to FIG. 5, FIG. 15, and FIG. 16. FIG. 15 is a schematic diagram of a structure of the power module 10 according to an implementation of this application. FIG. 16 is a partially enlarged view of an M part in FIG. 15. In a possible implementation, the power module 10 further includes a second metal layer-coated substrate 500 and electronic components 600 (as shown in FIG. 16). The second metal layer-coated substrate 500 is located on a surface of the metal layer of the first metal layer-coated substrate 100. The electronic component 600 is located on a side that is of the second metal layer-coated substrate 500 and that is away from the first metal layer-coated substrate 100, and is electrically connected to the second metal layer-coated substrate 500. The metal layer of the first metal layer-coated substrate 100 includes the first metal layer 120, the second metal layer 130, or another metal layer. The second metal layer-coated substrate 500 may be located on the surface of the first metal layer 120 or the second metal layer 130. In the implementation shown in FIG. 16, the electronic component 600 is located on the first surface 121 of the first metal layer 120. In some implementations, the electronic component 600 is located on the second metal layer 130. It should be noted that, to indicate a structural relationship between the second metal layer-coated substrate 500 and the electronic component 600, a structure of the first connection piece 300 in FIG. 15 is simplified. The structure of the first connection piece 300 in FIG. 15 is merely used for illustration. For the structure of the first connection piece 300 and a connection relationship between the first connection piece 300 and the chip 200, refer to related descriptions in FIG. 3 to FIG. 14.

Because a size of the electronic component 600 is generally small, if the electronic component 600 is directly soldered to the first metal layer-coated substrate 100, the metal layer of the first metal layer-coated substrate 100 needs to be provided with an insulating groove, and two electrodes of the electronic component 600 need to be electrically connected to the metal layers on both sides of the insulating groove. The first metal layer-coated substrate 100 is provided with the insulating groove, and this reduces space for arranging the chips 200. A large quantity of chips 200 are disposed on the first metal layer-coated substrate 100, and the pre-arranged chips 200 or another electronic component may be damaged when the groove is etched into the metal layer on the first metal layer-coated substrate 100. In this implementation, the electronic component 600 is joined by using the second metal layer-coated substrate 500. In this way, a soldering process of the electronic component 600 is simple. When the soldering process is compared with a process in which the electronic component 600 is directly soldered to the metal layer of the first metal layer-coated substrate 100, a step of providing the insulating groove on the metal layer of the first metal layer-coated substrate 100 may be omitted. In this way, a circuit design on the first metal layer-coated substrate 100 is simple. The insulating groove may be disposed on the second metal layer-coated substrate 500 in advance based on the size of the electronic component 600 and positions of the two electrodes of the electronic component 600. The insulating groove is etched into the second metal layer-coated substrate 500, without affecting performance of the chip 200 on the first metal layer-coated substrate 100. Then, the electronic component 600 is electrically connected to the second metal layer-coated substrate 500.

The second metal layer-coated substrate 500 includes a second insulating substrate 510 and metal layers located on both sides of the second insulating substrate 510. The electronic component 600 is electrically connected to the metal layer on one side of the second insulating substrate 510.

In a possible implementation, the electronic component 600 is a gate resistor 610 (as shown in FIG. 16). The second metal layer-coated substrate 500 is located on the first surface 121. The second metal layer-coated substrate 500 includes a fourth electrode 520 and a fifth electrode 530 that are spaced for insulation. Two ends of the gate resistor 610 are electrically connected to the fourth electrode 520 and the fifth electrode 530 respectively. The fourth electrode 520 is configured to receive a drive current, and the fifth electrode 530 is electrically connected to the third electrode 230 of the chip 200 by using a first conductive wire 710. The gate resistor 610 is joined by using the second metal layer-coated substrate 500, so that the soldering process of the gate resistor 610 is simple.

The fourth electrode 520 and the fifth electrode 530 are parts of the metal layer on the second insulating substrate 510. An insulated part between the fourth electrode 520 and the fifth electrode 530 is disposed based on a size of the gate resistor 610, so that the fourth electrode 520 and the fifth electrode 530 are spaced for insulation.

For example, there is a fourth groove 550 between the fourth electrode 520 and the fifth electrode 530. The fourth electrode 520 and the fifth electrode 530 are spaced for insulation by using the fourth groove 550. The fourth electrode 520, the fifth electrode 530, and the fourth groove 550 may be formed by performing an etching process on the metal layer on a side surface of the second metal layer-coated substrate 500.

In this implementation, the power module 10 further includes a second conductive wire 720 and a first connection terminal 731 (as shown in FIG. 15). The fourth electrode 520 is connected to the first connection terminal 731 by using the second conductive wire 720. An external control circuit sends the drive current to the first connection terminal 731. After the fourth electrode 520 receives the drive current, with reference to in FIG. 15 and FIG. 16, the drive current flows to the third electrode 230 of the chip 200 after sequentially passing through the first connection terminal 731, the second conductive wire 720, the fourth electrode 520, the gate resistor 610, the fifth electrode 530, and the first conductive wire 710. The third electrode 230 may be a gate. After receiving the drive current, the third electrode 230 may drive the first electrode 210 and the second electrode 220 to be connected. The gate resistor 610 is configured to improve switching performance of the chip 200, and can suppress high-frequency oscillation generated when the plurality of chips 200 are connected in parallel. The first conductive wire 710 is a transmission wire, for example, an aluminum wire or a copper wire.

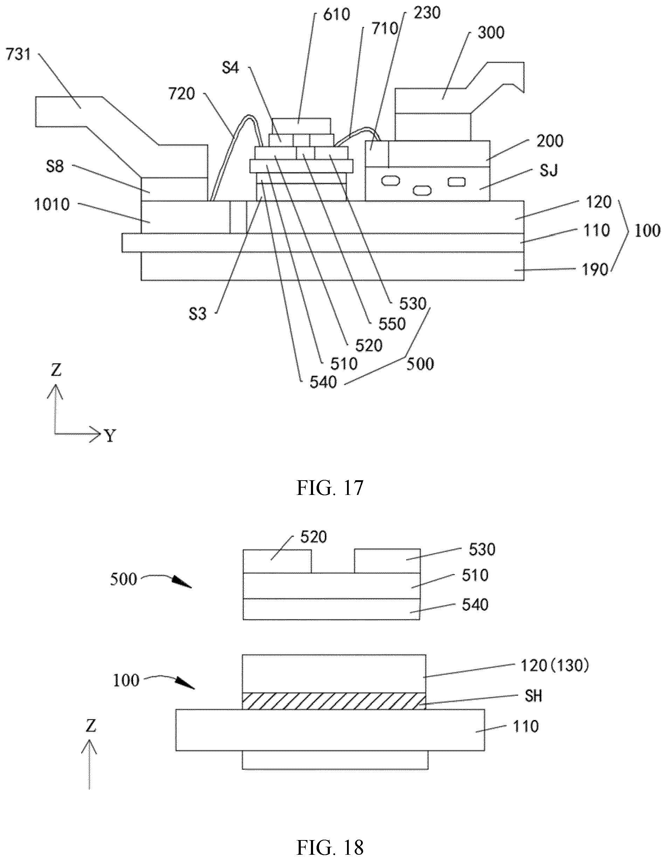

Refer to FIG. 17. The second metal layer-coated substrate 500 further includes a third metal layer 540 located on a side that is of the second insulating substrate 510 and that is away from the fourth electrode 520 and the fifth electrode 530. The third metal layer 540 is soldered to the first metal layer 120 on the surface of the first metal layer-coated substrate 100 by using third solder S3. The third solder S3 may be selected from at least one of tin solder and lead solder. The tin solder may be selected from at least one of SnSb5, SnSb8, SnSbAg, SAC305, multi-element reinforced SAC, and SnSb10. The third solder S3 may be the same as or different from the first solder S1. The third solder S3 may be the same as or different from the second solder S2.

The gate resistor 610 may be soldered to the fourth electrode 520 and the fifth electrode 530 by using fourth solder S4. The fourth solder S4 may be selected from at least one of tin solder and lead solder. The tin solder may be selected from at least one of SnSb5, SnSb8, SnSbAg, SAC305, multi-element reinforced SAC, and SnSb10. The fourth solder S4 may be the same as or different from the first solder S1. The third solder S3 may be the same as or different from the second solder S2.

The first connection terminal 731 may be soldered to a terminal metal layer 1010 at an edge of the first metal layer-coated substrate 100 by using eighth solder S8. The eighth solder S8 may be selected from at least one of tin solder and lead solder. The tin solder may be selected from at least one of SnSb5, SnSb8, SnSbAg, SAC305, multi-element reinforced SAC, and SnSb10.

In an implementation, when there is one gate resistor 610 and one second metal layer-coated substrate 500, the third electrodes 230 of the plurality of chips 200 in the first chip group 201 are electrically connected to the gate resistor 610 of the same second metal layer-coated substrate 500 by using the conductive wire. That is, one gate resistor 610 controls the first electrodes 210 and the second electrodes 220 in the plurality of chips 200 to be connected or disconnected.

In an implementation, when there are a plurality of gate resistors 610 and a plurality of second metal layer-coated substrates 500, and each gate resistor 610 is disposed on the second metal layer-coated substrate 500, the third electrode 230 of each chip 200 is electrically connected to the gate resistor 610 of one of the second metal layer-coated substrates 500 by using the conductive wire. That is, one gate resistor 610 controls the first electrode 210 and the second electrode 220 of one chip 200 to be connected or disconnected.

In this implementation, the chip 200 is located on the first metal layer 120, and the second metal layer-coated substrate 500 is soldered to a surface of the first metal layer 120, so that components can be distributed more compactly. In some implementations, the second metal layer-coated substrate 500 may be soldered to a surface of the second metal layer 130.

FIG. 18 is a schematic diagram of structures of the first metal layer-coated substrate 100 and the second metal layer-coated substrate 500. In a possible implementation, in the first metal layer-coated substrate 100, the first metal layer 120 and the second metal layer 130 are connected to the first insulating substrate 110 by using a metal soldering layer SH. In the second metal layer-coated substrate 500, the fourth electrode 520 and the fifth electrode 530 are attached to a surface of the second insulating substrate 510.

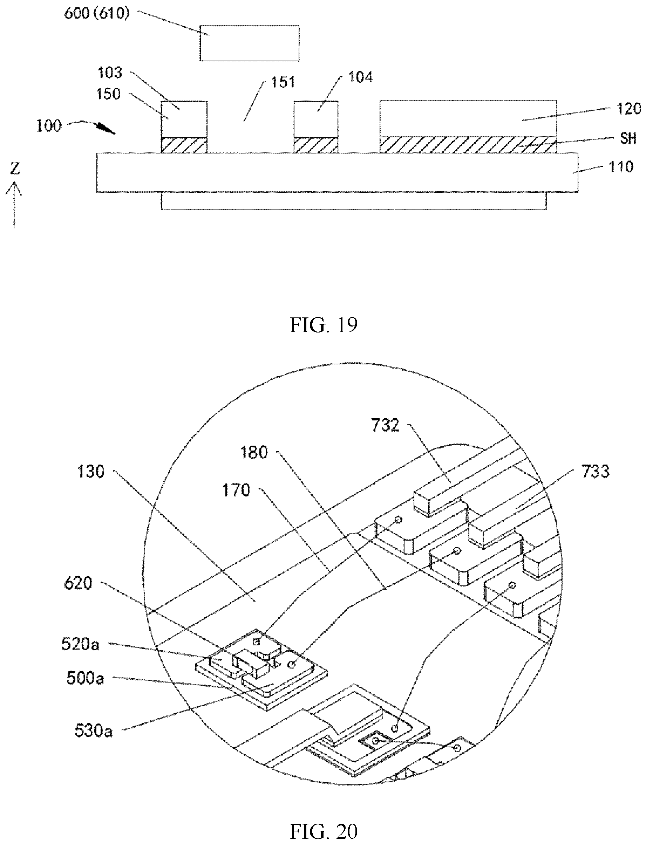

In this implementation, in the first metal layer-coated substrate 100, in a third direction Z, there are two metal layers on a side that is of the first insulating substrate 110 and that faces the chip 200. The two metal layers are respectively the metal soldering layer SH and the first metal layer 120. If the electronic component 600 is directly soldered to the first metal layer-coated substrate 100, a sixth electrode 103 and a seventh electrode 104 that are spaced for insulation need to be disposed on the first metal layer-coated substrate 100, because the electronic component 600 needs to conduct a current. Refer to FIG. 19. For example, a fourth metal layer 150 is etched into a part of the first metal layer 120. The fourth metal layer 150 and the rest of the first metal layer 120 are spaced for insulation. A second groove 151 is etched into the fourth metal layer 150 to form the sixth electrode 103 and the seventh electrode 104. In this case, a part of the fourth metal layer 150 and a part of the metal soldering layer SH that are between the sixth electrode 103 and the seventh electrode 104 need to be removed by using an etching process. A size of etching in the third direction Z is large, and this causes an increase in a diameter of the second groove 151. In other words, a size between the sixth electrode 103 and the seventh electrode 104 is large, and the size of the electronic component 600 (for example, the gate resistor 610) is small, and thus cannot be soldered to the sixth electrode 103 and the seventh electrode 104, or soldering reliability is poor. On this basis, in this implementation, the electronic component 600 is joined by using the second metal layer-coated substrate 500. Metal on the second metal layer-coated substrate 500 is directly bonded to the second insulating substrate 510, so that the formed fourth electrode 520 and fifth electrode 530 are also directly attached to the surface of the second insulating substrate 510. There is no metal soldering layer between the fourth electrode 520 and the fifth electrode 530, and the second insulating substrate 510. When the groove is provided through etching to form the fourth electrode 520 and the fifth electrode 530, etching on the metal soldering layer is not required. In this way, a size between the fourth electrode 520 and the fifth electrode 530 may be controlled to be small, and this facilitates soldering of the electronic component 600 (for example, the gate resistor 610).

In an implementation, the first metal layer-coated substrate 100 is an active metal brazed substrate. The active metal brazed substrate means that metal layers such as copper layers or aluminum layers are soldered to two surfaces of an insulating substrate by using metal solder. A circuit required by the power module 10, such as the first metal layer 120, the second metal layer 130, the first end metal layer 140, and the terminal metal layer 1010 may be formed through etching on the copper layers. A material of the first insulating substrate 110 in the first metal layer-coated substrate 100 is Si₃N₄ or AlN, so that reliability of soldering between the first insulating substrate 110 and metal plates on both sides of the first insulating substrate 110 is strong. In this way, good thermal conductivity is achieved, and heat dissipation effect of the power module 10 can be improved.

In an implementation, the second metal layer-coated substrate 500 is a direct bond copper substrate. The second insulating substrate 510 is an Al₂O₃ ceramic substrate or an AlN ceramic substrate, and the metal layer (for example, copper foil) is directly bonded to the second insulating substrate 510 at a high temperature. For example, the copper foil is directly bonded to the Al₂O₃ ceramic substrate at the high temperature, and then the copper foil is configured to form the fourth electrode 520 and the fifth electrode 530 based on a requirement. There is no other metal layer between the copper foil and the Al₂O₃ ceramic substrate, so that a size of a spacing between the fourth electrode 520 and the fifth electrode 530 is small, and this facilitates soldering of the gate resistor 610.

In a possible implementation, in the first metal layer-coated substrate 100, values of thicknesses of the first metal layer 120 and the second metal layer 130 are greater than or equal to 0.6 mm. When the value of the thickness of the first metal layer 120 is within the foregoing range, the first metal layer 120 has high power density, and may quickly transmit currents to the plurality of chips 200 connected in parallel. When the value of the thickness of the second metal layer 130 is within the foregoing range, the first metal layer-coated substrate 100 further has a heat conduction capability, and heat dissipation effect of the power module 10 is further improved. In this way, the second metal layer 130 has high power density, and may quickly transmit the currents to the plurality of chips 200 connected in parallel in the second chip group 202. Larger values of the thicknesses of the first metal layer 120 and the second metal layer 130 indicate better heat dissipation effect and higher power density. However, thicker first metal layer 120 and second metal layer 130 indicate a larger size of the insulating groove when the insulating groove is provided through etching. Because the size of the electronic component 600 (for example, the gate resistor 610) is small, this increases difficulty in the process of soldering the electronic component 600 to the two electrodes across the groove. On this basis, when the power density of the power module 10 is increased, the second metal layer-coated substrate 500 may be provided, to reduce difficulty in the process of soldering the electronic component 600.

For example, the values of the thicknesses of the first metal layer 120 and the second metal layer 130 are greater than or equal to 0.8 mm.

For example, the values of the thicknesses of the first metal layer 120 and the second metal layer 130 are greater than or equal to 1.2 mm.

In a possible implementation, the first metal layer-coated substrate 100 is an insulated metal substrate. The insulated metal substrate includes an insulating resin layer and metal layers located on both sides of the insulating resin layer. A required circuit is etched into the metal layer on one side based on an electrical interconnection requirement. The both sides of the insulating resin layer include the first metal layer 120 and the second metal layer 130. When the values of the thicknesses of the metal layers are greater than or equal to 0.6 mm, the power module 10 has high power density. The second metal layer-coated substrate 500 may be provided, to join the electronic component 600, and reduce the process difficulty of soldering the electronic component 600.

Still refer to FIG. 15. In a possible implementation, the power module 10 includes two second metal layer-coated substrates. One second metal layer-coated substrate 500 is configured to be soldered to the gate resistor 610, and the other second metal layer-coated substrate 500a is configured to be soldered to the thermistor 620. In some implementations, only one second metal layer-coated substrate may be used to be soldered to the thermistor 620.

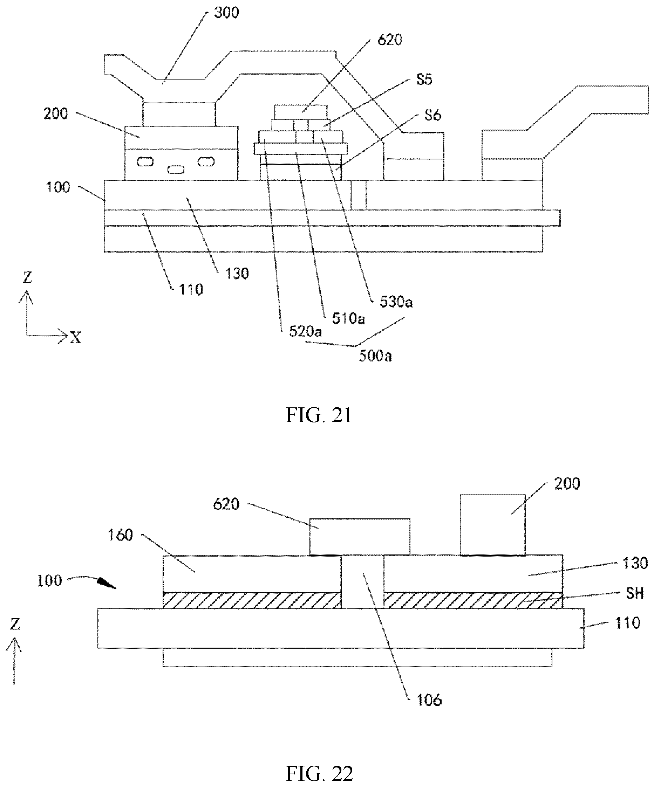

Refer to FIG. 20 and FIG. 21. FIG. 20 is a partially enlarged view of an N part in FIG. 15. FIG. 21 is a sectional view of a part that is of the power module 10 and that includes the thermistor 620. In this implementation, the electronic component 600 is the thermistor 620. The second metal layer-coated substrate 500a is located on the side that is of the second metal layer 130 and that is away from the first insulating substrate 110, and is disposed close to the chip 200 located on the second metal layer 130. The thermistor 620 is configured to monitor a temperature of the chip 200. In some implementations, the electronic component 600 is the thermistor 620. The second metal layer-coated substrate 500a is located on the side that is of the first metal layer 120 and that is away from the first insulating substrate 110, and is disposed close to the chip 200 located on the first metal layer 120. The thermistor 620 is configured to monitor the temperature of the chip 200. To be specific, the second metal layer-coated substrate 500 configured to join the thermistor 620 and the chip 200 are located on a same metal layer, for example, both are located on the first metal layer 120, or both are located on the second metal layer 130. In other implementations, based on a design requirement of the power module 10, both the second metal layer-coated substrate 500 configured to join the thermistor 620 and the chip 200 are disposed on another metal layer.

Refer to FIG. 20 and FIG. 21. In this implementation, the second metal layer-coated substrate 500a includes a fourth electrode 520a and a fifth electrode 530a that are spaced for insulation. Two ends of the thermistor 620 are electrically connected to the fourth electrode 520a and the fifth electrode 530a respectively. The power module 10 further includes a second connection terminal 732 and a third connection terminal 733 (as shown in FIG. 20). The fourth electrode 520a and the fifth electrode 530a are electrically connected to the second connection terminal 732 and the third connection terminal 733 respectively. The second connection terminal 732 and the third connection terminal 733 are connected to an external control circuit. The temperature of the chip 200 is monitored by using the thermistor 620. The thermistor 620 may be a negative temperature coefficient thermistor or a positive temperature coefficient thermistor. The second connection terminal 732 and the third connection terminal 733 may be soldered to terminal metal layers. The terminal metal layers under the connection terminals are spaced for insulation.

In this implementation, the power module 10 further includes a third conductive wire 170 and a fourth conductive wire 180. The fourth electrode 520a is connected to the second connection terminal 732 by using the third conductive wire 170. The fifth electrode 530a is connected to the third connection terminal 733 by using the fourth conductive wire 180. The third conductive wire 170 and the fourth conductive wire 180 may be aluminum wires or copper wires.

In this implementation, the thermistor 620 is disposed on the second metal layer-coated substrate 500a. The second metal layer-coated layer substrate 500a is disposed on the second metal layer 130, and the thermistor 620 is disposed close to the chip 200, so that temperature measurement is more accurate. If the thermistor 620 is directly soldered to the second metal layer 130, the thermistor 620 needs to be soldered to a groove between the second metal layer 130 and another metal layer. Refer to FIG. 22. For example, the power module 10 further includes a second end metal layer 160. A third groove 106 is disposed between the second metal layer 130 and the second end metal layer 160. Two ends of the thermistor 620 are disposed on the second metal layer 130 and the second end metal layer 160. Only one end of the thermistor 620 is connected to the second metal layer 130. The chip 200 is located on the second metal layer 130. When the chip 200 heats up through working, the temperature of the chip 200 is directly conducted to the second metal layer 130. In this case, a temperature of the second metal layer 130 approximates the temperature of the chip 200. When only one end of the thermistor 620 is connected to the second metal layer 130, and the other end of the thermistor 620 is connected to the second end metal layer 160, the second end metal layer 160 and the second metal layer 130 are spaced by using the third groove 106. In this case, heat of the second metal layer 130 cannot be conducted to the second end metal layer 160, and a temperature difference between the second end metal layer 160 and the second metal layer 130 is large. In this case, a temperature of the end that is of the thermistor 620 and that is connected to the second end metal layer 160 is lower than a temperature of the end that is of the thermistor 620 and that is connected to the second metal layer 130. As a result, overall accuracy of the thermistor 620 monitoring the temperature of the chip 200 is reduced. However, in this implementation, the second metal layer-coated substrate 500a is located at the second metal layer 130. The thermistor 620 is soldered to the second metal layer-coated substrate 500a (as shown in FIG. 21). Temperatures at the two ends of the thermistor 620 approximate each other. The second metal layer-coated substrate 500a is disposed on the first metal layer 120 and close to the chip 200, so that the accuracy of monitoring the temperature of the chip 200 can be improved.

It should be understood that when both the second metal layer-coated substrate 500 configured to join the thermistor 620 and the chip 200 are located on the first metal layer 120, the accuracy of monitoring the temperature of the chip 200 can also be improved.

The thermistor 620 may be soldered to the fourth electrode 520a and the fifth electrode 530a by using fifth solder S5. The fifth solder S5 may be selected from at least one of tin solder and lead solder. The tin solder may be selected from at least one of SnSb5, SnSb8, SnSbAg, SAC305, multi-element reinforced SAC, and SnSb10. The fifth solder S5 may be the same as or different from the first solder S1. The fifth solder S5 may be the same as or different from the second solder S2.

The second metal layer-coated substrate 500a may be soldered to a surface that is of the first metal layer 120 and that is away from the first insulating substrate 110 by using sixth solder S6. The sixth solder S6 may be selected from at least one of tin solder and lead solder. The tin solder may be selected from at least one of SnSb5, SnSb8, SnSbAg, SAC305, multi-element reinforced SAC, and SnSb10. The sixth solder S6 may be the same as or different from the first solder S1. The sixth solder S6 may be the same as or different from the second solder S2.

In this implementation, the first metal layer-coated substrate 100 is one of the active metal brazed substrate and the insulated metal substrate. The second metal layer-coated substrate 500a is the direct bond copper substrate.

In some implementations, the metal layer on the second metal layer-coated substrate 500 may be used as a signal trace. This helps improve flexibility of line distribution of the power module 10. Some lines may be made by using the metal layer on the first metal layer-coated substrate 100, and some lines may be made by using the metal layer on the second metal layer-coated substrate 500. In this way, line distribution is more flexible.

Still refer to FIG. 5. In a possible implementation, the power module 10 further includes a heat sink 800. The heat sink 800 is located on a side that is of the first metal layer-coated substrate 100 and that is away from the chip 200. A plurality of support assemblies 900 spaced apart from each other are disposed between the heat sink 800 and the first metal layer-coated substrate 100. The heat sink 800 may be a water-cooled heat sink. This is not limited herein. The heat sink 800 is configured to dissipate heat from the power module 10, to improve the power density of the power module 10. In this implementation, to improve heat dissipation effect, the heat sink 800 may be soldered, by using seventh solder S7, to the side that is of the first metal layer-coated substrate 100 and that is away from the chip 200. Compared with a manner in which the heat sink 800 is bonded, by using thermally conductive silicone, to the first metal layer-coated substrate 100, a manner in which soldering is performed uses a soldering material with better heat conduction effect than the thermally conductive silicone.

The first metal layer-coated substrate 100 includes a fifth metal layer 190 located on a side that is of the first insulating substrate 110 and that is away from the first metal layer 120. The heat sink 800 is soldered to the fifth metal layer 190 by using the seventh solder S7. The heat sink 800 includes a heat sink base 810 and a heat sink cover 820. Heat sink fins 811 are disposed on the heat sink base 810. Channels are formed between the heat sink fins 811. A cooling medium may flow in the channels, and heat dissipation is implemented by using the cooling medium.

Generally, when the heat sink 800 and the first metal layer-coated substrate 100 are soldered, pressure needs to be applied to the heat sink 800 and the first metal layer-coated substrate 100. The support assembly 900 may prevent the seventh solder S7, from being extruded, that is between the first metal layer-coated substrate 100 and the heat sink 800 and that melts during soldering with pressure applied. This avoids a case in which the seventh solder S7 fails due to being excessively thin. Before soldering is performed, the support assembly 900 may be bonded on a surface that is of the heat sink 800 and that faces the first metal layer-coated substrate 100, or the support assembly 900 may be bonded on a surface that is of the first metal layer-coated substrate 100 and that faces the heat sink 800. The support assembly 900 may be a metal wire or a metal strip. The support assembly 900 may be further configured to control a thickness of the seventh solder S7, and a thickness of the support assembly 900 may be designed based on a requirement, so that the seventh solder S7 meets a requirement.

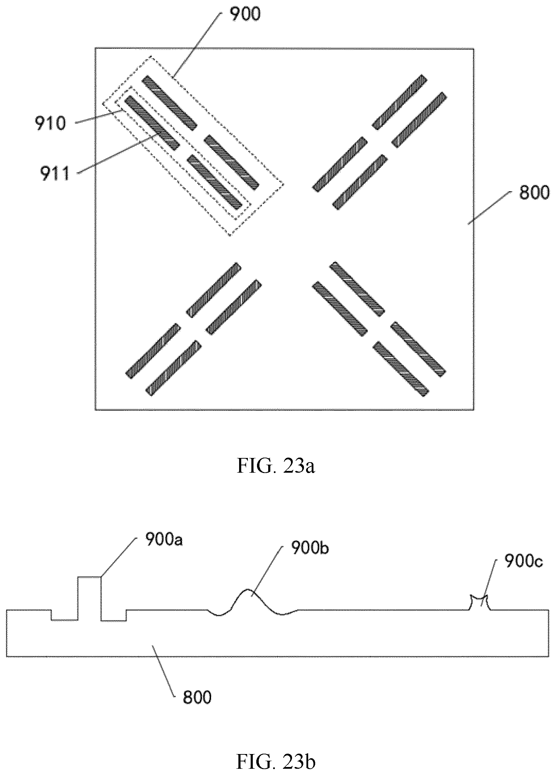

Refer to FIG. 23a. In a possible implementation, the support assembly 900 includes two support bars 910 disposed in parallel. The support bar 910 includes at least two support sections 911. Two adjacent support sections 911 are arranged in an extension direction of the support bar 910 and are spaced apart from each other. When the seventh solder S7 is filled between the two support bars 910 disposed in parallel, it is difficult to extrude the seventh solder S7 during soldering with pressure applied. However, bubbles are generated during soldering under a high temperature. If the bubbles do not escape, voids are formed at a soldering layer, affecting soldering reliability. The support sections 911 are spaced apart from each other, to help the bubbles escape and reduce the voids. In addition, the two support bars 910 disposed in parallel may be configured to enhance support strength for the first metal layer-coated substrate 100 and the heat sink 800.

Refer to FIG. 23b. In some implementations, the support assembly 900 may be formed, by using a stamping manner, on the surface that is of the heat sink 800 and that faces the first metal layer-coated substrate 100. The support assembly is boss-shaped, as shown by 900a in FIG. 23b. Alternatively, the support assembly is bump-shaped, as shown by 900b in FIG. 23b. Alternatively, the support assembly is crater-shaped, as shown by 900c in FIG. 23b. In another implementation, the support assembly 900 may also be of another shape. In some implementations, the boss-shaped, bump-shaped, or volcano-shaped support assemblies 900 on the surface of the heat sink 800 may be one or a combination of more than one of the foregoing shapes. In some implementations, there may be one or more boss-shaped, bump-shaped, or volcano-shaped support assemblies 900. This may be specifically set based on a requirement.

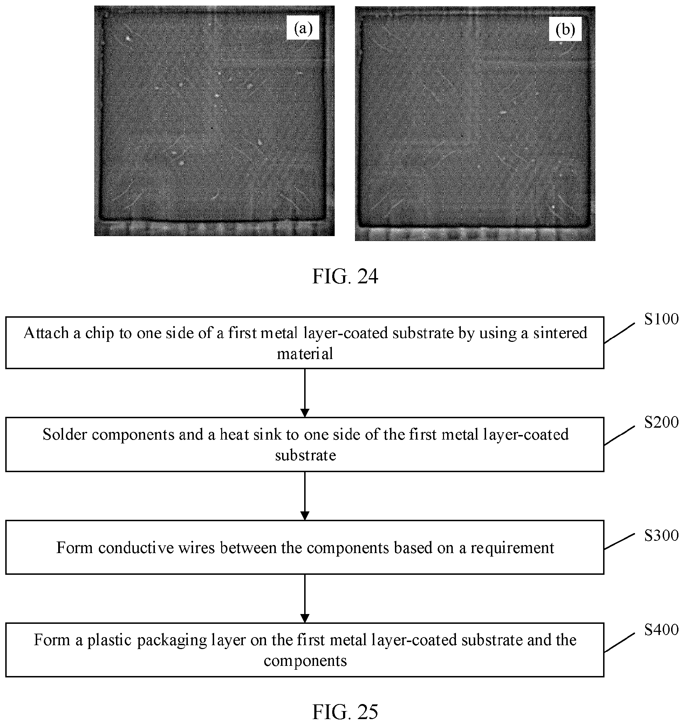

Refer to FIG. 24. FIG. 24 is a 3D-x-ray image of a soldering side between the heat sink 800 and the first metal layer-coated substrate 100 in the power module 10 according to an implementation of this application. In FIG. 24, (a) is a 3D-x-ray image of a soldering side between the seventh solder S7 and the first metal layer-coated substrate 100. In FIG. 24, (b) is a 3D-x-ray image of a soldering side between the seventh solder S7 and the heat sink 800. In this implementation, the support assemblies 900 in the implementation shown in FIG. 23a are used. The SnSb5 solder is used as the seventh solder S7 to solder the heat sink 800 to the first metal layer-coated substrate 100. The power module 10 is subject to a temperature shock test. Conditions for the temperature shock test are as follows: holding at -40°C (a low temperature) for 15 minutes; holding at 125°C (a high temperature) for 15 minutes; and performing 1000 cycles, where one cycle is holding the power module 10 at the high temperature for one time and at the low temperature for one time. It can be seen from FIG. 24 that corner regions at edges in the figures are not white, and this indicates that the soldering side between the seventh solder S7 and the heat sink 800 does not peel off, and the soldering side between the seventh solder S7 and the first metal layer-coated substrate 100 does not peel off. This indicates that the support assemblies 900 shown in FIG. 23a can improve reliability of soldering between the heat sink 800 and the first metal layer-coated substrate 100.

In an implementation, the seventh solder S7 is selected from at least one of SnSb5, SnSb8, SnSbAg, SAC305, multi-element reinforced SAC, lead-based high-temperature solder, SnSb10, hyper-peritectic Sn-Sb, and Sn-Sb-X. The lead-based high-temperature solder is solder that contains more than or equal to 85% lead and melts only at a high temperature. In Sn-Sb-X, Sn and Sb are doped with other elements, such as nickel, bismuth, and copper. When soldering is performed, a soldering temperature may be set based on a specific material of the seventh solder S7. For example, when the lead-based high-temperature solder is used, a value of the soldering temperature may be set to be greater than or equal to 300°C. For another example, when SAC305 is used, a value of the soldering temperature may be set to 260°C.

In some implementations, to save soldering time and soldering processes, a reflow soldering process is performed for one time to solder components in the power module 10 and solder the heat sink 800. Alternatively, the reflow soldering process is performed for two times. When the reflow soldering process is performed for the first time, the components are soldered to the first metal layer-coated substrate 100. When the reflow soldering process is performed for the second time, the heat sink 800 is soldered to the side that is of the first metal layer-coated substrate 100 and that is away from the chip 200. The components include the first connection piece 300, the second connection piece 400, the thermistor 620, the gate resistor 610, and the connection terminals.

Still refer to FIG. 5. For example, when solder materials of the first solder S1, the second solder S2, the third solder S3, the fourth solder S4, the fifth solder S5, the sixth solder S6, the seventh solder S7, and the eighth solder S8 are selected from at least one of SnSb5, the first solder S1, the second solder S2, the third solder S3, the fourth solder S4, the fifth solder S5, the sixth solder S6, the seventh solder S7, and the eighth solder S8 is used for completing soldering by performing the reflow soldering process for one time, and a temperature of the reflow soldering process is set to 260°C, because SnSb8, SnSbAg, SAC305, and multi-element reinforced SAC, SnSb5, SnSb8, SnSbAg, SAC305 and multi-element reinforced SAC are medium-temperature solder, and a maximum temperature that the thermistor 620 can tolerate is 260°C.

For example, when the solder materials of the first solder S1, the second solder S2, the third solder S3, the fourth solder S4, the fifth solder S5, the sixth solder S6, and the eighth solder S8 are selected from at least one of SnSb5, SAC305, and multi-element reinforced SAC, and the solder material of the seventh solder S7 is selected from at least one of the lead-based high-temperature solder, SnSb10, hyper-peritectic Sn-Sb, and Sn-Sb-X, the seventh solder S7 is high-temperature solder, and melts only at a high temperature to implement soldering. Maximum soldering temperatures that the components can tolerate are low. For example, the maximum soldering temperature that the thermistor 620 can tolerate is 260°C. In this case, the reflow soldering process needs to be performed for two times. The temperature is set to 300°C (or greater than 300°C) when the reflow soldering process is performed for the first time. The seventh solder S7 is used for soldering, and the heat sink 800 is soldered to the side that is of the first metal layer-coated substrate 100 and that is away from the chip 200. Then, the reflow soldering process is performed for the second time. The temperature is set to 260°C when the reflow soldering process is performed for the second time. In this case, the first solder S1, the second solder S2, the third solder S3, the fourth solder S4, the fifth solder S5, the sixth solder S6, and the eighth solder S8 are used for soldering, and the components such as the first connection piece 300, the thermistor 620, the gate resistor 610, and the first connection terminal 731 corresponding to the solder are soldered to the first metal layer-coated substrate 100.

For example, when the solder materials of the first solder S1, the second solder S2, the third solder S3, the fourth solder S4, the fifth solder S5, the sixth solder S6, the seventh solder S7, and the eighth solder S8 are selected from at least one of the lead-based high-temperature solder, SnSb10, hyper-peritectic Sn-Sb, and Sn-Sb-X, the thermistor 620 may be a thermistor that can tolerate a maximum soldering temperature higher than 300°C, so that the power module 10 may be soldered by performing the reflow soldering process for one time.

For example, when the solder materials of the first solder S1, the second solder S2, the third solder S3, the fourth solder S4, the fifth solder S5, the sixth solder S6, and the eighth solder S8 are selected from at least one of Sn-Sb-X, SnSb5, SnSb8, SnSbAg, SAC305, and multi-element reinforced SAC, and the seventh solder S7 is the lead-based high-temperature solder, SnSb10, or the hyper-peritectic Sn-Sb, a soldering temperature of the seventh solder S7 is higher than soldering temperatures of the first solder S1, the second solder S2, the third solder S3, the fourth solder S4, the fifth solder S5, the sixth solder S6, and the eighth solder S8, the reflow soldering process may be performed for two times to complete soldering. In this embodiment, temperatures are set to be greater than or equal to 300°C in the two times of the reflow soldering process, but temperatures are different in the two times of the reflow soldering process. A temperature for soldering the seventh solder S7 is higher than temperatures for soldering the first solder S1, the second solder S2, the third solder S3, the fourth solder S4, the fifth solder S5, the sixth solder S6, and the eighth solder S8.

In some implementations, to increase reliability of soldering between the first metal layer-coated substrate 100 and the heat sink 800, or to increase reliability of soldering between the components on the first metal layer-coated substrate 100, the solder may be selected based on materials of surfaces on which soldering is hard to perform.

Refer to FIG. 25. In an implementation, this application further provides a method for preparing the power module 10, including step S100, step S200, step S300, and step S400. Detailed steps are as follows.

Step S100: Attach the chip 200 to one side of the first metal layer-coated substrate 100 by using a sintered material SJ.

For example, the first metal layer-coated substrate 100 is a substrate with an active metal layer, and includes the first insulating substrate 110 and a copper layer soldered to one side of the first insulating substrate 110. The first insulating substrate 110 is a SiN ceramic substrate, and a thickness of the copper layer is 0.8 mm. The first metal layer 120, the second metal layer 130, the first end metal layer 140, and the like are etched into the copper layer based on a requirement. In some implementations, a thickness of the copper layer may be set based on a requirement.

Optionally, an insulated metal substrate may be selected as the first metal layer-coated substrate 100.

In the chip 200 (as shown in FIG. 6), the first electrode 210 is located on a side that is of the chip body 240 and that faces the first metal layer 120. The first electrode 210 includes Ti/Ni/Au, where Ti/Ni/Au indicates that Ti, Ni, and Au are sequentially soldered to one side of the chip body 240 (as shown in FIG. 6). Optionally, the first electrode 210 may alternatively be one of Ti/Ni/Ag, Ti/NiV/Ag, Ti/NiV/Au, Ni(P)/Pd/Au, Ni(P)/Pd/Ag, Ni(P)/Au, or Ni(P)/Ag, where Ni(P) indicates that the element Ni is doped with the element P, and NiV is an alloy of the element Ni and the element V Optionally, the second electrode 220 is one of Ti/Ni/Au, Ti/Ni/Ag, Ti/NiV/Ag, Ti/NiV/Au, Ni(P)/Pd/Au, Ni(P)/Pd/Ag, Ni(P)/Au, or Ni(P)/Ag.

Optionally, to improve electrical properties of the chip 200, a NiSi layer may be further disposed between the first electrode 210 and the chip body 240.

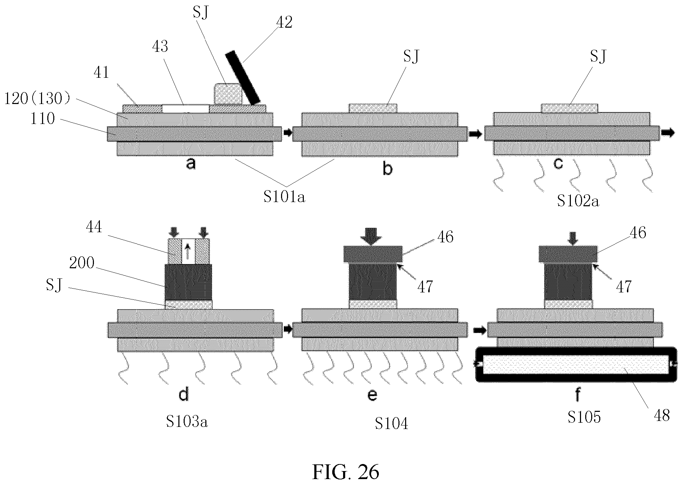

For example, when the sintered material SJ is copper paste or silver paste, refer to FIG. 26. The chip 200 may be attached to the first metal layer-coated substrate 100 by using the following steps.

Step S101a: Print the sintered material SJ on the first metal layer-coated substrate.

During specific implementation, as shown in step a and step b in FIG. 26, the sintered material SJ (the silver paste) may be printed on a sintering region corresponding to the first metal layer-coated substrate 100 by using a squeegee 42 in a printing process using a stencil 41 or a screen printing process. Compared with the screen printing process, the printing process using the stencil 41 has low costs and is easy to perform. Therefore, optionally, in this application, the copper paste or the silver paste is printed on the sintering region corresponding to the first metal layer-coated substrate 100 by using the stencil printing process.

In an implementation, a side surface of an opening 43 of the stencil 41 may be set to an oblique surface or an oblique curved surface tapering from the bottom to top. In this way, a thickness of the sintered material at edges of the opening 43 is thin, to reduce an edge protrusion of the sintered material SJ after printing, improve printing quality, and reduce a stress risk of the chip 200. If a same thickness is set for the edges and a middle part of the opening 43, thick sintered material SJ is filled at the edges of the opening 43. When the stencil is taken out after printing, the stencil pulls up the sintered material close to the edges of the opening, causing the edge protrusion of the sintered material SJ. If the edges of the opening 43 are set to be tapering from the bottom to top, less sintered material SJ is filled at the edges of the opening 43. In this way, a problem of the edge protrusion of the sintered material SJ can be avoided.

For example, a thickness of the printed copper paste or silver paste may be controlled to be between 30 µm and 160 µm.

This may be specifically designed based on an actual product. This is not limited herein.

In an implementation, an area of the printed copper paste or silver paste may be set to be greater than an area of a corresponding sintering region on the chip 200, to absorb an alignment error between the chip 200 and the sintered material SJ. A boundary of the copper paste or the silver paste may extend 20 µm to 300 µm outwards a target boundary (a boundary of the sintering region of the chip in an ideal state).

Step S102a: Perform pre-drying on the sintered material SJ after printing.

During specific implementation, pre-drying is performed on the printed copper paste or silver paste to prevent the sintered material from being crushed during sintering with pressure applied.

For example, as shown in step c in FIG. 26, pre-drying may be performed in an atmosphere of N2 for 5 minutes to 40 minutes at a temperature of 100°C to 180°C on the sintered material SJ (the copper paste or the silver paste) printed on the first metal layer-coated substrate 10.

Step S103a: Attach the chip 200 to the sintered material SJ of the first metal layer-coated substrate 100 and apply pressure to the chip 200.

During specific implementation, as shown in step d in FIG. 26, a metal suction nozzle 44 may be first used to pick up the chip 200 by suction. The chip 200 is picked up. Then, the sintered material SJ (the copper paste or the silver paste) is aligned by using a vision identification system, and then the chip 200 is fastened to the dried sintered material SJ (the copper paste or the silver paste) and pressure is applied to the chip 200.

For example, a condition for attaching the chip 200 may be as follows: a temperature is controlled to be between 100°C and 180°C; pressure is controlled to be between 0.1 MPa and 10 MPa; and time is controlled to be between 10 ms and 999 ms. To be specific, at a temperature of 100°C to 180°C, pressure of 0.1 MPa to 10 MPa is applied, for at least 10 ms, to the chip 200 attached to the first metal layer-coated substrate 100.

In some embodiments, a silver film may be used as a sintered material.

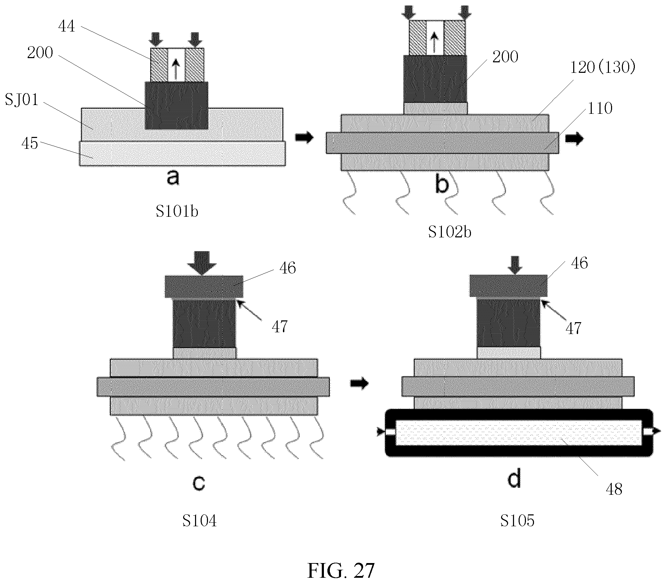

For example, when the sintered material SJ is a silver film SJ01, refer to FIG. 27. The chip 200 may be attached to the first metal layer-coated substrate 100 by using the following steps.

Step S101b: Adhere the silver film SJ01 to a side that is of the chip 200 and that faces the first metal layer-coated substrate 100.

During specific implementation, as shown in step a in FIG. 27, the metal suction nozzle 44 may be used to pick up the chip 200 by suction, and a temperature of the metal suction nozzle 44 is between 80°C and 200°C. The chip 200 is pressed against the large silver film SJ01, and pressure of 0.1 MPa to 5 MPa is applied for 1 ms to 10000 ms. In this way, the silver film SJ01 under the chip 200 is compressed and semi-sintered, and adheres to the chip 200. A silver film support layer 45 is disposed under the silver film SJ01. After the chip 200 is attached to the silver film SJ01, the silver film support layer 45 is removed. Then, the silver film SJ01 is attached to the first metal layer 120 or the second metal layer 130 of the first metal layer-coated substrate 100.

In an implementation, the surface of the first metal layer-coated substrate 100 may be bare copper or plated with silver. To enhance bonding force, silver plating is generally used. A thickness of a silver-plated layer is about 0.1 µm to 30 µm, and the silver film is attached to the silver-plated layer.

Step S102b: Attach, to the first metal layer-coated substrate 100, the chip 200 to which the silver film SJ01 is attached, and apply pressure to the chip 200.

In a specific implementation, as shown in step b in FIG. 27, the chip 200 may be first picked up by suction. Then, the first metal layer-coated substrate 100 is aligned by using the vision identification system, and then the chip 200 to which the silver film SJ01 is attached is fastened to the first metal layer-coated substrate 100 and pressure is applied to the chip 200.

For example, a condition for attaching the chip 200 may be as follows: a temperature is controlled to be between 100°C and 180°C; pressure is controlled to be between 0.1 MPa and 10 MPa; and time is controlled to be between 10 ms and 999 ms. To be specific, at a temperature of 100°C to 180°C, pressure of 0.1 MPa to 10 MPa is applied, for at least 10 ms, to the chip 200 attached to the first metal layer-coated substrate 100.

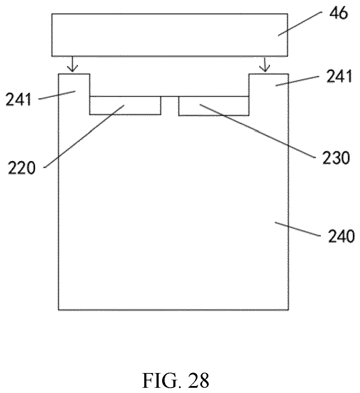

Refer to FIG. 28. In an implementation, the second electrode 220 and the third electrode 230 in the chip 200 are lower than parts that are of the chip body 240 and that are around the second electrode 220 and the third electrode 230, so that a pressure resistance ring 241 higher than the second electrode 220 and the third electrode 230 is formed around the second electrode 220 and the third electrode 230. The pressure resistance ring 241 is a part of the chip body 240. A material of the pressure resistance ring 241 is SiC. A height of the pressure resistance ring 241 is 10 µm higher than a height of the second electrode 220 and a height of the third electrode 230. In this way, when pressure is applied to the chip 200, a pressure head 46 is in contact with the pressure resistance ring 241, and the second electrode 220 and the third electrode 230 are not damaged by the pressure.

After the chip 200 is attached, step S104 is performed.

Step S104: Perform pressure-assisted sintering on the chip 200 attached to the first metal layer-coated substrate 100.

The pressure-assisted sintering indicates that pressure is applied to a bonded body at a high temperature, to increase density of the bonded body, facilitate atomic diffusion in particles of the sintered material, the sintered material, and the interface of the bonded body, and enhance bonding strength and bonding reliability. The used pressure-assisted sintering process is not limited in this application, and may be any well-known method.

During specific implementation, as shown in step e in FIG. 26 and step c in FIG. 27, the pressure head 46 may be configured to perform the pressure-assisted sintering on the chip 200 attached to the first metal layer-coated substrate 10. An example in which an area of the pressure head is 50 mm*50 mm is used. A parallelism degree of the pressure head 46 may be set to ≤5 µm, to reduce warping of a sintered product.

For example, a sintering condition for performing the pressure-assisted sintering is as follows: a sintering temperature is controlled to be between 200°C and 300°C, applied pressure is controlled to be between 5 MPa and 30 MPa, and sintering time is controlled to be between 1 min and 10 min.

During specific implementation, a pressure-assisted sintering procedure may be performed in an air environment. To prevent the product from being oxidized, in a protective atmosphere or a vacuum environment, the pressure-assisted sintering is performed on the chip 200 attached to the first metal layer-coated substrate 100. The protective atmosphere may be a reductive atmosphere or an inert atmosphere. For example, the protective atmosphere may be N2, a gas mixture of N2 and H2, Ar, He, or the like. This is not limited herein.

To prevent the pressure head 46 from damaging the chip 200 in the sintering procedure, as shown in step e in FIG. 27 and step c in FIG. 26, when the pressure-assisted sintering is performed on the chip 200 attached to the first metal layer-coated substrate 100, a removable stress relief film 47 may be further placed between the chip 200 and the pressure head 46. Therefore, during the pressure-assisted sintering, the stress relief film 47 can prevent the pressure head 46 from directly contacting the chip 200, and reduce damage on the chip 200 caused when the pressure head 46 applies the stress in a centralized manner to the chip 200. After the pressure-assisted sintering is completed, the stress relief film 47 may be removed.

For example, a thickness of the stress relief film 47 may be set to 50 µm to 90 µm. This is not limited herein.

For example, the stress relief film 47 may be an organic film such as a Teflon film. This is not limited herein.

Step S105: Cool the product obtained through pressure-assisted sintering.

In an implementation, after the sintering is completed, the product may be cooled in the protective atmosphere and a pressurized state, to control a warping degree of the sintered product. As shown in step f in FIG. 26 and step d in FIG. 27, to enhance cooling, the cooling may be performed by circulating cooling water 48 or by using nitrogen.

Step S200: Solder the components and the heat sink 800 to one side of the first metal layer-coated substrate 100.

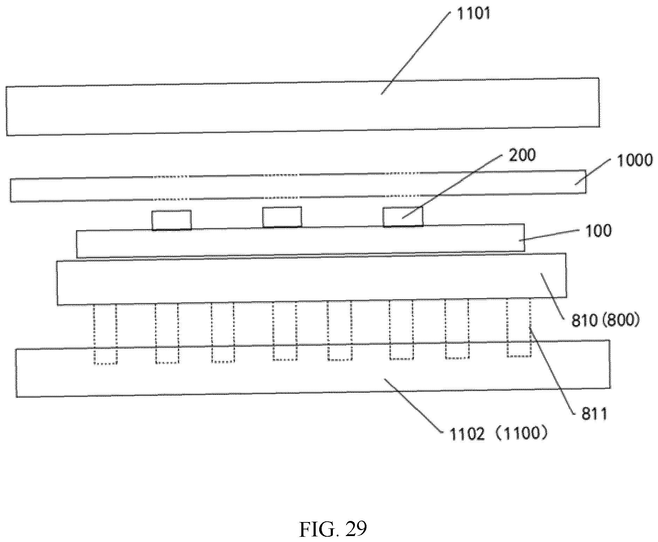

Before the power module 10 is soldered, the components and corresponding solder are pasted at preset positions, and the heat sink 800 is disposed at the bottom of the first metal layer-coated substrate 100. Refer to FIG. 29. A soldering jig 1100 may be used to secure the components of the power module 10 and the heat sink 800. The components include the first connection piece 300, the second connection piece 400, the thermistor 620, the gate resistor 610, or a lead frame 1000. The lead frame 1000 is configured to be cut to form connection terminals according to a requirement, for example, the first connection terminal 731, the second connection terminal 732, and the third connection terminal 733. After soldering is completed, an unnecessary part is cut off from the lead frame 1000 according to a requirement, to form the first connection terminal 731, the second connection terminal 732, and the third connection terminal 733. FIG. 29 is merely used for illustration, and does not represent a structure of the power module 10 and a structure shape of the soldering jig in a specific embodiment.

The soldering jig 1100 includes an upper jig 1101 and a lower jig 1102. The upper jig 1101 and the lower jig 1102 have positioning holes. The first metal layer-coated substrate 100, to which the chip 200 is attached and in which the electronic component 600 and the corresponding solder are placed, and the lead frame 1000 are placed between the upper jig 1101 and the lower jig 1102, and are secured according to a requirement. To adjust the warping degree and pressure of the first metal layer-coated substrate and ensure warping of the lead frame 1000 during reflow soldering, the upper jig 1101 and the lower jig 1102 are pressed against each other tight by using a bolt. For example, a spring groove and a high-temperature resistant spring may be disposed on an upper pressing plate. The first metal layer-coated substrate 100 and the lead frame 1000 can be pressed flat by using spring force. After the product and the jig 1100 for reflow soldering are fastened and mounted, the product and the jig 1100 for reflow soldering are placed in a vacuum reflow oven for reflow soldering. The jig at the bottom for reflow soldering has hole positions, in which the heat sink fins 811 on the heat sink base 810 of the heat sink 800 may be placed.

In an implementation, the support assembly 900 is pre-mounted on the soldering side of the heat sink 800 by using ultrasonic waves, to prevent the solder, from being extruded, that is between the first metal layer-coated substrate 100 and the heat sink 800 and that melts during reflow soldering with pressure applied. This avoids a case in which the solder fails due to being excessively thin. For example, the support assembly 900 is a metal wire segment, such as a copper wire or an aluminum wire As shown in FIG. 23a, these metal wire segments may be used to support the first metal layer-coated substrate 100, and also help bubbles escape during reflow soldering, to avoid generating voids and affecting soldering reliability.

In an implementation, the materials of the solder may be set, to implement soldering of the heat sink 800, the thermistor 620, the gate resistor 610, the second metal layer-coated substrate 500, and the lead frame 1000 by performing reflow soldering for one time or performing reflow soldering for a plurality of times. This may be specifically set according to a requirement. Corresponding forms of the solder may be a solder lug or solder paste.

In an implementation, when the solder is the solder lug, vacuum reflow under formic acid vapor is used, and a die attachment machine is configured to place the solder lug at a corresponding position. Then, the second metal layer-coated substrate 500, the thermistor 620, the gate resistor 610, the first connection piece 300, and the lead frame 1000 are placed on corresponding solder lugs by using a die attachment device. The gate resistor 610 and the thermistor 620 may be soldered to the second metal layer-coated substrate 500, or the second metal layer-coated substrate 500 may be placed on the solder lug on the first metal layer-coated substrate 100.

In an implementation, when the solder is the solder paste, a position at which soldering is to be performed is coated with the solder paste through 3D printing or glue dispensing. The second metal layer-coated substrate 500, the thermistor 620, the gate resistor 610, the first connection piece 300, and the lead frame 1000 are placed on the corresponding solder paste by using the die attachment device. The bolt is tightly fastened, and the product is placed in the vacuum reflow oven for soldering.

Step S300: Form conductive wires between the components according to a requirement.

An internal interconnection in the power module 10 is implemented by using the conductive wire, where the conductive wire is an aluminum wire or a copper wire. In this implementation, the fourth electrode 520a in the second metal layer-coated substrate 500a under the thermistor 620 is connected to the second connection terminal 732 by using the third conductive wire 170 (as shown in FIG. 20). The fifth electrode 530a is connected to the third connection terminal 733 by using the fourth conductive wire 180. For another example, the fourth electrode 520 in the second metal layer-coated substrate 500 under the gate resistor 610 is connected to the first connection terminal 731 by using the second conductive wire 720 (as shown in FIG. 16).

In an implementation, when the first solder S1, the second solder S2, the third solder S3, the fourth solder S4, the fifth solder S5, the sixth solder S6, the seventh solder S7, and the eighth solder S8 are solder lugs, because the solder lugs are in a solid state form, during reflow soldering in step S200, the product surface is clean and does not need to be cleaned, and the conductive wire may be directly formed.

In an implementation, when the first solder S1, the second solder S2, the third solder S3, the fourth solder S4, the fifth solder S5, the sixth solder S6, the seventh solder S7, and the eighth solder S8 are solder paste, because the solder paste is in a solid state form, during reflow soldering in step S200, the solder paste is sputtered to a surface of the product, or to the metal layer such as the first metal layer 120 or the second metal layer 130. Therefore, the electronic components 600, another component, or the metal layers such as the first metal layer 120 and the second metal layer 130 have the solder paste, an organic matter or solder flux in the solder paste. The conductive wire is formed after cleaning is performed on the surface of the product.

Step S400: Form a plastic packaging layer 1200 on the first metal layer-coated substrate 100 and the components.

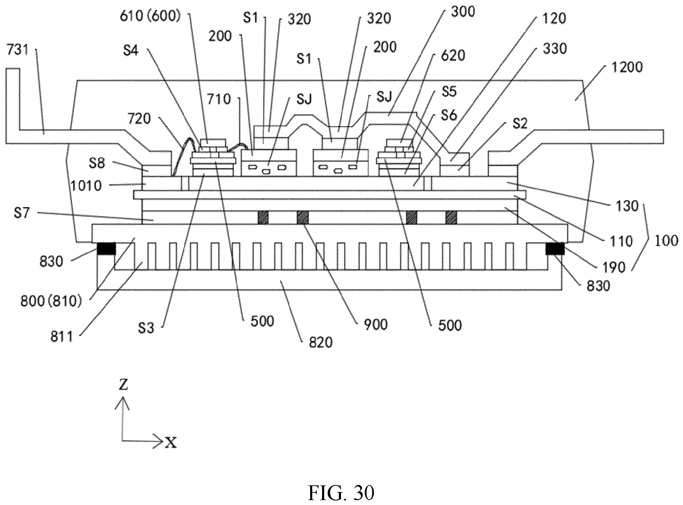

After step S300 is completed, the product is placed in a plastic packaging mold for plastic packaging. The first metal layer-coated substrate 100 and the electronic component 600 are packaged between the plastic packaging layer 1200 and the heat sink 800 (as shown in FIG. 30).

To increase bonding of the plastic packaging layer 1200 with the components such as the first metal layer-coated substrate 100 and the electronic component 600 in the power module 10 and a reflow soldering surface, an interface stress moderator is used to enhance bonding strength of the plastic packaging layer 1200. An interface bonding reinforcing agent may be an organic matter, and may be sprayed for use, or the product is immersed in the agent. A stress relief film is formed after drying processing. An organic matter containing copper may also be formed on a surface of the metal layer (for example, the copper layer) of the first metal layer-coated substrate 100. Strength of bonding the organic matter with the plastic packaging layer 1200 and the metal copper layer is increased.

In some implementations, a proper material for the plastic packaging layer 1200 may be selected and optimized, to improve a plastic packaging interface and implement proper module plastic packaging.

To prevent layering between a plastic package material and a plastic package interface and to improve reliability of the power module, the plastic package material is a plastic package material with a low modulus. For example, the plastic package material may be formed by using a material with an elastic modulus between 0.5 GPa and 20 GPa, for example, an epoxy plastic package material. This is not limited herein.

In some implementations, the method for preparing the power module 10 further includes: After plastic packaging is completed, the lead frame 1000 is cut to form corresponding connection terminals, for example, the first connection terminal, the second connection terminal, and the third connection terminal. Electroplating is performed on the connection terminals, to prevent corrosion of the connection terminals and improve mounting performance and soldering wetting.

Still refer to FIG. 30. In some implementations, the heat sink 800 includes the heat sink base 810 and the heat sink cover 820. The heat sink base 810 may be first soldered to the side that is of the first metal layer-coated substrate 100 and that is away from the chip 200. After the plastic packaging step is completed, the heat sink cover 820 covers the heat sink base 810 in a sealed manner by using sealing rings 830. Channels are formed between the heat sink base 810 and the heat sink cover 820, to facilitate cooling medium circulation.

In some implementations, the heat sink cover 820 and the heat sink base 810 may be soldered with solder, to perform sealing soldering between the heat sink cover 820 and the heat sink base 810.

The power module, the power supply system, the vehicle, and the photovoltaic system according to embodiments of this application are described in detail above. The principles and embodiments of this application are described herein by using specific examples. The description about the foregoing embodiments is merely provided to help understand the method and core ideas of this application. In addition, a person of ordinary skill in the art can make variations and modifications in terms of the specific embodiments and application scopes according to the ideas of this application. In conclusion, the content of this specification shall not be construed as a limitation to this application.

## Claims

1. A power module, wherein the power module comprises:
a first metal layer-coated substrate, comprising a first insulating substrate and a first metal layer located on a side of the first insulating substrate, wherein the first metal layer comprises a first surface away from the first insulating substrate;
a plurality of chips, wherein the chip comprises a first electrode and a second electrode, the plurality of chips are located on a side that is of the first metal layer and that is away from the first insulating substrate, the first electrode of each of the plurality of chips is electrically connected to the first metal layer, at least two of the plurality of chips are spaced in a first direction, at least two of the plurality of chips are spaced in a second direction, and the second direction and the first direction are parallel to the first surface and intersect; and
a first connection piece, located on sides that are of the plurality of chips and that are away from the first insulating substrate, wherein the first connection piece comprises a first main body part and a plurality of first contact parts, the second electrode of each of the plurality of chips is in contact with at least one of the first contact parts, there is a part of the first main body part between at least one pair of adjacent first contact parts, and the first main body part and the first metal layer are spaced for insulation.

2. The power module according to claim 1, wherein in a thickness direction of the chip, the first main body part is isolated from the second electrode of the chip, the first connection piece comprises one or more slots, the slot protrudes from the first main body part towards the first surface, and a slot bottom of the slot is the first contact part.

3. The power module according to claim 1 or 2, wherein the first connection piece comprises one or more bent structures, and the bent structure comprises the first contact part that is in contact with the second electrode of the chip.

4. The power module according to any one of claims 1 to 3, wherein the first connection piece is an integrally formed structure.

5. The power module according to any one of claims 1 to 4, wherein there is the part of the first main body part between each pair of adjacent first contact parts.

6. The power module according to any one of claims 1 to 5, wherein the first contact parts are distributed at edges of the first main body part.

7. The power module according to any one of claims 1 to 6, wherein the power module further comprises a second metal layer, the first metal layer and the second metal layer are located on the same side of the first insulating substrate, orthographic projections of the first metal layer and the second metal layer are spaced on the first insulating substrate, the first connection piece further comprises a second contact part, and the second contact part is electrically connected to the second metal layer.

8. The power module according to any one of claims 1 to 7, wherein the power module further comprises a second metal layer-coated substrate and an electronic component, the second metal layer-coated substrate is located on the first surface, and the electronic component is located on a side that is of the second metal layer-coated substrate and that is away from the first metal layer-coated substrate, and is electrically connected to the second metal layer-coated substrate.

9. The power module according to claim 8, wherein the chip further comprises a third electrode, the electronic component is a gate resistor, the second metal layer-coated substrate is located on the first surface, the second metal layer-coated substrate comprises a fourth electrode and a fifth electrode that are spaced for insulation, two ends of the gate resistor are electrically connected to the fourth electrode and the fifth electrode respectively, the fourth electrode is configured to receive a drive current, and the fifth electrode is electrically connected to the third electrode of the chip by using a first conductive wire.

10. The power module according to claim 9, wherein in the first metal layer-coated substrate, the first metal layer is connected to the first insulating substrate by using a metal soldering layer, the second metal layer-coated substrate further comprises a second insulating substrate, and the fourth electrode and the fifth electrode are attached to a surface of the second insulating substrate.

11. The power module according to claim 8, wherein the electronic component is a thermistor; the second metal layer-coated substrate is located on the side that is of the first metal layer and that is away from the first insulating substrate, and is disposed close to the chip; and the thermistor is configured to monitor a temperature of the chip.

12. The power module according to any one of claims 1 to 11, wherein the power module further comprises a heat sink, the heat sink is located on a side that is of the first metal layer-coated substrate and that is away from the chip, and a plurality of support assemblies spaced apart from each other are disposed between the heat sink and the first metal layer-coated substrate.

13. The power module according to claim 12, wherein the support assembly comprises two support bars disposed in parallel, the support bar comprises at least two support sections, and two adjacent support sections are spaced and arranged in an extension direction of the support bar.

14. A power supply system, wherein the power supply system comprises a power supply, an electric device, and the power module according to any one of claims 1 to 13, the power supply is connected to an input end of the power module, the electric device is connected to an output end of the power module, and the power module is configured to: convert a direct current output by the power supply into an alternating current, and transmit the alternating current to the electric device.

15. A vehicle, wherein the vehicle comprises a vehicle body and the power supply system according to claim 14, and the power supply system is installed on the vehicle body.

16. A photovoltaic system, comprising a photovoltaic module and the power module according to any one of claims 1 to 13, wherein the photovoltaic module is electrically connected to the power module, and a direct current generated by the photovoltaic module is converted into an alternating current by using the power module.
